# EUROPEAN PATENT APPLICATION

(11) **EP 4 651 682 A1**
(43) Date of publication of application: **19.11.2025**
(21) Application number: 25175806.6
(22) Date of filing: 12.05.2025
(51) Int. Cl.: H10H 29/01, H10H 29/14, H10H 29/39, H10H 29/49

(54) **DISPLAY DEVICE AND METHOD OF FABRICATING THE SAME**

(30) Priority: 14.05.2024 KR 20240063191
(71) Applicant: Samsung Display Co., Ltd., Yongin-si, Gyeonggi-do 17113 (KR)
(72) Inventor: SO, Myeong Su, 17113 Yongin-si (KR); KIM, Jun Youn, 17113 Yongin-si (KR); PARK, Sang Ho, 17113 Yongin-si (KR); KIM, Ki Bum, 17113 Yongin-si (KR)
(74) Representative: Walaski, Jan Filip

(57) **Abstract**

A display device including a display area and a non-display area formed around the display area comprises a substrate, a pixel circuit layer disposed on the substrate, and including a plurality of sub-pixel circuits disposed in the display area, a plurality of first conductive connectors disposed on the pixel circuit layer, and a display element layer disposed on the first conductive connectors. The display element layer includes a plurality of light emitting elements disposed in the display area, electrically connected to the sub-pixel circuits through the first conductive connectors disposed in the display area and configured to emit light in response to signals applied from the sub-pixel circuits, and a plurality of dummy light emitting elements disposed in the non-display area. The light emitting elements and the dummy light emitting elements include the same material.

## Description

### CROSS-REFERENCE TO RELATED APPLICATION

The present application claims priority to Korean Patent Application number 10-2024-0063191 filed on 14 May 2024 in the Korean Intellectual Property Office.

### BACKGROUND

### 1. Field

The present disclosure relates to a display device and a method of fabricating the display device.

### 2. Description of the Related Art

The recent increase in interest in display has led to continuous research and development on display devices.

### SUMMARY

Various embodiments of the present disclosure are directed to a display device and a method of fabricating the display device, which may simplify a fabrication process, shorten the time it takes to perform the fabrication process, and reduce the production cost.

Various embodiments of the present disclosure are directed to a display device and a method of fabricating the display device, which may reduce the risk of electrical short-circuits.

Various embodiments of the present disclosure are directed to a display device with improved light output efficiency, and a method of fabricating the display device.

However, features of the present disclosure are not limited to the above-described features, and various modifications are possible without departing from the spirit and scope of the present disclosure.

According to an embodiment of the present disclosure, a display device including a display area and a non-display area formed around the display area comprises a substrate, a pixel circuit layer disposed on the substrate, and including a plurality of sub-pixel circuits disposed in the display area, a plurality of first conductive connectors disposed on the pixel circuit layer, and a display element layer disposed on the first conductive connectors. The plurality of first conductive connectors may include first conductive connectors disposed in the display area and first conductive connectors disposed in the non-display area. The display element layer may include a plurality of light emitting elements disposed in the display area, electrically connected to the sub-pixel circuits through the first conductive connectors disposed in the display area and configured to emit light in response to signals applied from the sub-pixel circuits, and a plurality of dummy light emitting elements disposed in the non-display area. The light emitting elements and the dummy light emitting elements may include the same material.

In an embodiment, each of the light emitting elements and the dummy light emitting elements may include a first semiconductor layer disposed on the first conductive connectors, an active layer disposed on the first semiconductor layer, a second semiconductor layer disposed on the active layer, and a second conductive connector disposed on the second semiconductor layer. The first semiconductor layer, the active layer, the second semiconductor layer, and the second conductive connector may be sequentially stacked in a thickness direction of the substrate. The first conductive connectors disposed in the display area may be in contact with the light emitting elements and are connected to the sub-pixel circuits. The first conductive connectors disposed in the non-display area may be in with the dummy light emitting elements and are separated from the sub-pixel circuits.

In an embodiment, the non-display area may include a dummy area surrounding the display area, a cathode contact area surrounding the dummy area, a pad area spaced apart from the cathode contact area by a distance, and a dam area surrounding the pad area. The dummy light emitting elements may include a plurality of first dummy light emitting elements disposed in the dummy area, a plurality of second dummy light emitting elements disposed in the cathode contact area, a plurality of third dummy light emitting elements disposed in the pad area, and a plurality of fourth dummy light emitting elements disposed in the dam area. A cross-section of the first dummy light emitting elements, the second dummy light emitting elements, the third dummy light emitting elements, or the fourth dummy light emitting elements may be identical to a cross-section of the light emitting elements disposed in the display area along the thickness direction.

In an embodiment, the fourth dummy light emitting elements may extend in a closed-loop shape along the dam area.

In an embodiment, the display element layer may further include an insulating layer covering at least portions of top surfaces of and side surfaces of the first conductive connectors, the light emitting elements, and the dummy light emitting elements, a reflective layer disposed on the insulating layer and configured to guide light emitted from the light emitting elements in the thickness direction, a protective layer disposed on the reflective layer, and a metal mesh disposed on the protective layer in space between the light emitting elements adjacent to each other, space between the dummy light emitting elements adjacent to each other, and space between any one of the light emitting elements and any one of the dummy light emitting elements adjacent to each other. A portion of a top surface of the protective layer may not be covered by the metal mesh.

In an embodiment, the insulating layer, the reflective layer, and the protective layer may include a plurality of first contact holes extended to at least portions of the top surfaces of the light emitting elements, and a trench extended to portions of the top surfaces of the fourth dummy light emitting elements.

In an embodiment, the display element layer may further include a cathode electrode disposed on the protective layer and the metal mesh. The cathode electrode may be electrically connected to the top surface of the light emitting elements through the first contact holes. A portion of the cathode electrode that is formed in the cathode contact area and a portion of the cathode electrode that is formed in the pad area may be separated from each other by the trench disposed in the dam area.

In an embodiment, the display element layer may further include a thin-film encapsulation layer disposed on the cathode electrode. The thin-film encapsulation layer may contact the top surface of each of the fourth dummy light emitting elements through the trench.

In an embodiment, the insulating layer, the reflective layer, and the protective layer may further include a plurality of second contact holes extended to at least portions of the top surfaces of the first conductive connectors contacting the second dummy light emitting elements, and a plurality of third contact holes extended to at least portions of the top surfaces of the first conductive connectors contacting the third dummy light emitting elements. A first end of the metal mesh disposed in the cathode contact area may be electrically connected to at least portions of the top surfaces of the first conductive connectors contacting the second dummy light emitting elements through the second contact holes. A second end of the metal mesh disposed in the cathode contact area may be electrically connected to the cathode electrode. A first end of the metal mesh disposed in the pad area may be electrically connected to at least portions of the top surfaces of the first conductive connectors contacting the third dummy light emitting elements through the third contact holes. A second end of the metal mesh disposed in the pad area may be electrically connected to the cathode electrode.

In an embodiment, the thin-film encapsulation layer may include a fourth contact hole extended to a top surface of the cathode electrode disposed in the pad area. The display element layer may further include a pad electrode disposed on the thin-film encapsulation layer and electrically connected to the cathode electrode through the fourth contact hole.

According to an embodiment of the present disclosure, a method of fabricating a display device including a display area and a non-display area enclosing the display area comprises forming, on a first substrate, a pixel circuit layer in which a plurality of sub-pixel circuits is disposed, forming a first conductive material layer on the pixel circuit layer, sequentially forming a first semiconductor material layer, an active material layer, and a second semiconductor material layer on a second substrate, bonding the first conductive material layer and the second semiconductor material layer to contact each other, and separating the second substrate from the first semiconductor material layer, forming a second conductive material layer on the first semiconductor material layer, and forming a plurality of light emitting elements disposed in the display area and a plurality of dummy light emitting elements disposed in the non-display area by removing portions of the second conductive material layer, the first semiconductor material layer, the active material layer, and the second semiconductor material layer.

In an embodiment, the method may further include forming a first insulating material layer on the second conductive material layer, the light emitting elements, and the dummy light emitting elements.

In an embodiment, the method may further include removing portions of the first insulating material layer and the first conductive material layer, wherein a side surface of the first conductive material layer and a portion of a top surface of the pixel circuit layer may be exposed, forming a second insulating material layer on the first insulating material layer, the exposed side surface of the first conductive material layer and the exposed portion of the top surface of the pixel circuit layer, forming a reflective material layer on the second insulating material layer, and forming a protective material layer on the reflective material layer.

In an embodiment, the method may further include forming a third conductive material layer on the protective material layer, and planarizing the third conductive material layer. A portion of the protective material layer may be exposed through the planarization of the third conductive material layer.

In an embodiment, the method may further include forming a plurality of first contact holes by removing portions of the protective material layer, the reflective material layer, the second insulating material layer, and the first insulating material layer, wherein at least a portion of a top surface of the second conductive material layer disposed in the display area may be exposed through the first contact holes, and forming a fourth conductive material layer on the protective material layer and the third conductive material layer, wherein the fourth conductive material layer may be electrically connected to the second conductive material layer disposed in the display area through the first contact holes.

In an embodiment, the method may further include forming a thin-film encapsulation material layer on the fourth conductive material layer, and disposing a plurality of lenses on a portion of the thin-film encapsulation material layer overlapping the light emitting elements in a thickness direction of the first substrate.

In an embodiment, the method may further include forming a fourth conductive material layer on the exposed portion of the protective material layer and the third conductive material layer, and forming a thin-film encapsulation material layer on the fourth conductive material layer.

In an embodiment, the method may further include forming a second insulating material layer on the first insulating material layer, forming a reflective material layer on the second insulating material layer, and forming a protective material layer on the reflective material layer.

In an embodiment, the method may further include forming a plurality of second contact holes by removing portions of the protective material layer, the reflective material layer, the second insulating material layer, and the first insulating material layer, wherein a portion of a top surface of the first conductive material layer disposed in the non-display area may be exposed through the second contact holes, forming a third conductive material layer on the protective material layer and the exposed portion of the top surface of the first conductive material layer disposed in the non-display area, wherein the third conductive material layer may be electrically connected to the first conductive material layer through the second contact holes, and forming a metal mesh by planarizing the third conductive material layer, wherein a portion of the protective material layer may be exposed through the planarization of the third conductive material layer.

In an embodiment, the method may further include forming a fourth conductive material layer on the protective material layer and the metal mesh, and forming a thin-film encapsulation material layer on the fourth conductive material layer.

In an embodiment, the method may further include forming a third contact hole by removing a portion of the thin-film encapsulation material layer, wherein a portion of a top surface of the fourth conductive material layer disposed in the non-display area may be exposed through the third contact hole, and forming a fifth conductive material layer on the exposed portion of the fourth conductive material layer disposed in the non-display area, wherein the fifth conductive material layer may be electrically connected to the fourth conductive material layer through the third contact hole.

In an embodiment, the method may further include forming a fourth conductive material layer on the exposed portion of the protective material layer and the third conductive material layer, forming a fourth contact hole by removing portions of the fourth conductive material layer, the protective material layer, the reflective material layer, the second insulating material layer, and the first insulating material layer, wherein a top surface of the second conductive material layer disposed in the non-display area may be exposed through the fourth contact hole, and forming a thin-film encapsulation material layer on the top surface of the second conductive material layer exposed through the fourth contact hole, the first insulating material layer, the second insulating material layer, the reflective material layer, a portion of the protective material layer, and the fourth conductive material layer.

The technical solutions of the present disclosure may not be limited to the above, and other technical solutions of the present disclosure will be clearly understandable to those having ordinary skill in the art from the disclosures provided below together with accompanying drawings.

### BRIEF DESCRIPTION OF THE DRAWINGS

FIG. 1 is a block diagram illustrating a display device.
FIG. 2 is a block diagram illustrating any one of sub-pixels of FIG. 1.
FIG. 3 is a sectional view illustrating the display panel of FIG. 1.
FIG. 4 is a sectional view illustrating the display panel of FIG. 1.
FIG. 5 is a plan view illustrating the display panel of FIG. 1.
FIG. 6 is a sectional view taken along a line A-A' and a line B-B' of FIG. 5.
FIG. 7 is an enlarged plan view illustrating area C of FIG. 5.
FIG. 8 is a sectional view illustrating a display panel at the step of forming a pixel circuit layer on a substrate and forming a first conductive connector on the pixel circuit layer.
FIG. 9 is a sectional view illustrating a display panel at the step of forming a first semiconductor material layer, an active material layer, and a second semiconductor material layer on a second substrate.
FIG. 10 is a sectional view illustrating a display panel at the step of bonding a first conductive material layer and the second semiconductor material layer to contact each other, and separating a second substrate from the first semiconductor material layer.
FIG. 11 is a sectional view illustrating the display panel at the step of forming a second conductive material layer on the second semiconductor material layer.
FIG. 12 is a sectional view illustrating a display panel at the step of forming a plurality of light emitting elements in a display area and a plurality of dummy light emitting elements in a non-display area by removing portions of the second conductive material layer, the second semiconductor material layer, the active material layer, and the first semiconductor material layer.
FIG. 13 is a sectional view illustrating the display panel at the step of forming a first insulating material layer on the first conductive material layer, the light emitting elements, and the dummy light emitting elements.
FIG. 14 is a sectional view illustrating the display panel at the step of removing portions of the first insulating material layer and the first conductive material layer.
FIG. 15 is a sectional view illustrating the display panel at the step of forming a second insulating material layer on the first insulating material layer and an exposed side surface of the first conductive connector and a portion of a top surface of the pixel circuit layer, and forming a reflective material layer and a protective material layer on the second insulating material layer.
FIG. 16 is a sectional view illustrating the display panel at the step of forming first contact holes by removing portions of the protective material layer, the reflective material layer, the second insulating material layer, and the first insulating material layer.
FIG. 17 is a sectional view illustrating the display panel at the step of forming a third conductive material layer on the protective material layer and portions of a top surface of the first conductive connector exposed through the first contact holes.
FIG. 18 is a sectional view illustrating the display panel at the step of planarizing the third conductive material layer and exposing a portion of the protective material layer.
FIG. 19 is a sectional view illustrating the display panel at the step of forming a plurality of second contact holes by removing portions of the protective material layer, the reflective material layer, the second insulating material layer, and the first insulating material layer.
FIG. 20 is a sectional view illustrating the display panel at the step of forming a fourth conductive material layer on the protective material layer and second conductive connectors of the light emitting elements.
FIG. 21 is a sectional view illustrating the display panel at the step of forming a plurality of third contact holes by removing portions of the fourth conductive material layer, the protective material layer, the reflective material layer, the second insulating material layer, and the first insulating material layer.
FIG. 22 is a sectional view illustrating the step of forming a thin-film encapsulation material layer on a cathode electrode and the second conductive connectors of the fourth dummy light emitting elements.
FIG. 23 is a sectional view illustrating the display panel at the step of forming a lens array on the light emitting elements.
FIG. 24 is a sectional view illustrating the display panel at the step of forming a fourth contact hole by removing a portion of the thin-film encapsulation material layer.
FIG. 25 is a sectional view illustrating the display panel at the step of forming a pad electrode on the cathode electrode positioned in a pad area.
FIG. 26 is a block diagram illustrating a display system.
FIG. 27 is a perspective diagram illustrating an application example of the display system of FIG. 26.
FIG. 28 is a diagram illustrating a head mounted display device of FIG. 27 that is worn by a user.

### DETAILED DESCRIPTION

Hereinafter, embodiments of the present disclosure will be described in detail with reference to the attached drawings. In the following description, only the parts necessary for understanding the operations in accordance with the present disclosure will be described, and explanation of the other parts will be omitted not to make the gist of the present disclosure unclear. Accordingly, the present disclosure is not limited to the embodiments set forth herein but may be embodied in other types. Rather, these embodiments are provided so that the present disclosure will be thorough and complete, and will fully convey the technical principles of the disclosure to those skilled in the art.

It will be understood that when an element is referred to as being "coupled" or "connected" to another element, an element may be directly coupled or connected to the other element, or intervening elements may be present therebetween. The terminology used herein is for the purpose of describing particular embodiments only and is not intended to be limiting. For example, the singular forms are intended to include the plural forms as well, unless the context clearly indicates otherwise. In addition, when an element is referred to as "comprising" or "including" a component, it does not preclude another component but may further include the other component unless the context clearly indicates otherwise. "at least one of X, Y, and Z" and "at least one selected from the group consisting of X, Y, and Z" may be construed as X only, Y only, Z only, or any combination of two or more of X, Y, and Z (for instance, XYZ, XYY, YZ, and ZZ). As used herein, the term "and/or" can include any and all combinations of one or more of the associated listed items.

Here, the terms "first," "second," etc. may be used herein to describe various types of elements, and may be used to distinguish these elements from other elements. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element or feature's relationship to another element(s) or feature(s), as illustrated in the drawings. Spatially relative descriptors are intended to encompass different orientations of an apparatus in use, operation, and/or manufacture in addition to the orientation depicted in the drawings. For example, if the device in the drawings is turned upside down, elements described as "below" or "beneath" other elements or features would then be oriented "above" the other elements or features. Thus, the term "below" can encompass both an orientation of above and below. Furthermore, the device may be oriented in other directions (e.g., rotated 90 degrees or at other orientations), and, as such, the spatially relative descriptors used herein interpreted accordingly.

Various embodiments will be described with reference to drawings illustrating idealized embodiments. As such, variations from the shapes of the illustrations as a result, for example, of manufacturing techniques and/or tolerances, are to be expected. Therefore, embodiments disclosed herein should not be construed as limited to the particular illustrated shapes of regions, but are to include deviations in shapes that result from, for instance, manufacturing. As such, the shapes illustrated in the drawings may not illustrate the actual shapes of regions of a device, and, as such, are not intended to be limiting.

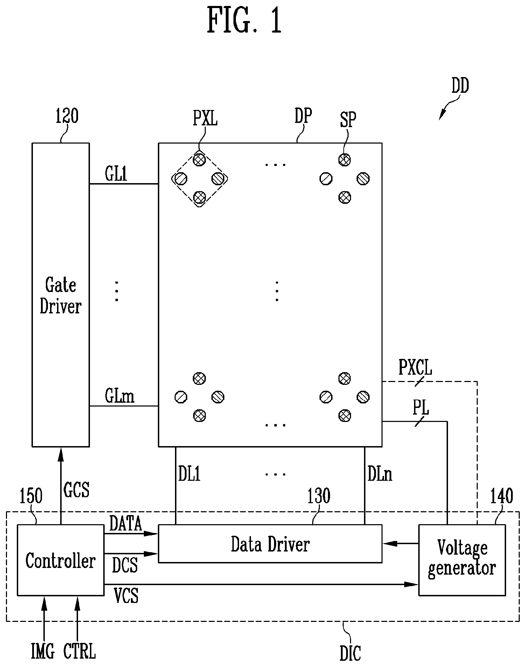

FIG. 1 is a block diagram illustrating a display device DD.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. Furthermore, the sub-pixels SP may be connected to the data driver 130 through first to n-th data lines DL1 to DLn.

The sub-pixels SP may generate light in two or more colors. For example, each of the sub-pixels SP may generate light in a color such as red, green, blue, cyan, magenta, or yellow.

Two or more sub-pixels among the sub-pixels SP may form one pixel PXL. For example, the pixel PXL may include four sub-pixels SP, as illustrated in FIG. 1. However, the pixel is not limited to the aforementioned example. In another example, the pixel PXL may include two sub-pixels SP. As such, the pixel PXL may emit light of various colors and various luminance depending on the combination of light emitted from the sub-pixels included therein.

The gate driver 120 may be connected to sub-pixels SP arranged in a row direction through first to m-th gate lines GL1 to GLm. The gate driver 120 may output gate signals to the first to m-th gate lines GL1 to GLm in response to a gate control signal GCS received from the controller 150. The gate control signal GCS may include a start signal indicating a beginning of a frame of each of the sub-pixels SP and a horizontal synchronization signal, and the like.

The gate driver 120 may be disposed on one side of the display panel DP. However, it is not limited to the aforementioned example. For example, the gate driver 120 may be divided into two or more drivers that are physically and/or logically distinguished from each other. The drivers may be disposed on a first side of the display panel DP and a second side of the display panel DP opposite to the first side. As such, the gate driver 120 may be disposed around the display panel DP in various forms and positions.

The data driver 130 may be connected to sub-pixels SP arranged in a column direction through the first to n-th data lines DL1 to DLn. The data driver 130 may receive image data DATA and a data control signal DCS from the controller 150. The data driver 130 may be operated in response to the data control signal DCS. The data control signal DCS may include a source start signal, a source shift clock, a source output enable signal, and the like.

The data driver 130 may receive voltages from the voltage generator 140. The data driver 130 may apply, using received voltages, data signals having grayscale voltages corresponding to the image data DATA to the first to n-th data lines DL1 to DLn. When a gate signal is applied to each of the first to m-th gate lines GL1 to GLm, data signals corresponding to the image data DATA may be applied to the first to n-th data lines DL1 to DLn. Hence, the sub-pixels SP may generate light corresponding to the data signals, allowing the display panel DP to display an image.

The gate driver 120 and the data driver 130 may include complementary metal-oxide semiconductor (CMOS) circuit elements.

The voltage generator 140 may operate in response to a voltage control signal VCS provided from the controller 150. The voltage generator 140 is configured to generate a plurality of voltages and provide the generated voltages to components of the display device DD such as the gate driver 120, the data driver 130, and the controller 150. The voltage generator 140 may receive an input voltage from an external device of the display device DD and generate a plurality of voltages by regulating the received voltage.

The voltage generator 140 may generate a first power voltage and a second power voltage. The generated first and second power voltages may be provided to the sub-pixels SP through power lines PL. In another example, at least one of the first and second power voltages may be provided from an external device to the display device DD.

In addition, the voltage generator 140 may provide various voltages and/or signals. For example, the voltage generator 140 may provide one or more initialization voltages to be applied to the sub-pixels SP. For example, during a sensing operation for sensing electrical characteristics of the sub-pixels SP and/or transistors electrically connected to the sub-pixels SP, a certain reference voltage may be applied to each of the first to n-th data lines DL1 to DLn. The voltage generator 140 may generate the reference voltage and transmit the reference voltage to the data driver 130.

In another example, during a display operation for displaying an image on the display panel DP, common pixel control signals may be applied to the sub-pixels SP, and the voltage generator 140 may generate the pixel control signals. The voltage generator 140 may provide pixel control signals to the sub-pixels SP through pixel control lines PXCL. Although FIG. 1 illustrates that the pixel control lines PXCL are connected between the voltage generator 140 and the display panel DP, they are not limited thereto. For example, the pixel control lines PXCL may be connected between the gate driver 120 and the display panel DP. In such a case, the pixel control signals may be transmitted from the gate driver 120 to the sub-pixels SP through the pixel control lines PXCL.

The controller 150 may control the overall operations of the display device DD. The controller 150 may receive input image data IMG and a control signal CTRL from an external device. The controller 150 may provide, in response to the control signal CTRL, a gate control signal GCS to the gate driver 120, a data control signal DCS to the data driver 130, and a voltage control signal VCS to the voltage generator 140, respectively.

The controller 150 may convert the input image data IMG to be suitable for the display device DD or the display panel DP and output image data DATA. The controller 150 may align the input image data IMG to be suitable for the sub-pixels SP on a row basis and then output the image data DATA.

Two or more components of the data driver 130, the voltage generator 140, and the controller 150 may be mounted into a single integrated circuit. As illustrated in FIG. 1, the data driver 130, the voltage generator 140, and the controller 150 may be included in a driver integrated circuit DIC. In such a case, the data driver 130, the voltage generator 140, and the controller 150 may be components that are functionally separated from each other in the single driver integrated circuit DIC. However, they are not limited thereto, and at least one of the data driver 130, the voltage generator 140, and the controller 150 may be provided as a component separated from the driver integrated circuit DIC.

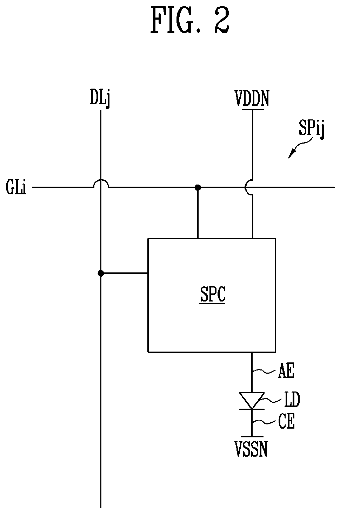

FIG. 2 is a block diagram illustrating any one of the sub-pixels SP of FIG. 1.

In FIG. 2, a sub-pixel SPij is illustrated, disposed on an i-th row (where i is an integer equal to or greater than 1 and less than or equal to m) and a j-th column (where j is an integer equal to or greater than 1 and less than or equal to n) among the sub-pixels SP of FIG. 1.

Referring to FIG. 2, the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL illustrated in FIG. 1 to receive a first power voltage. The second power voltage node VSSN may be connected to another one of the power lines PL illustrated in FIG. 1 to receive a second power voltage. Here, the first power voltage may have a voltage level higher than the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD may be configured to emit light based on current flowing from the anode electrode AE to the cathode electrode CE.

The sub-pixel circuit SPC may be connected both to an i-gate line GLi among the first to m-th gate lines GL1 to GLm of FIG. 1 and to a j-th data line DLj among the first to n-th data lines DL1 to DLn of FIG. 1. In response to a gate signal received through the i-th gate line GLi, the sub-pixel circuit SPC may control the light emitting element LD to emit light based on a data signal received through the j-th data line DLj. The sub-pixel circuit SPC may be further connected to the pixel control lines PXCL of FIG. 1. In such a case, the sub-pixel circuit SPC may further control the light emitting element LD in response to pixel control signals received through the pixel control lines PXCL.

For the sake of the aforementioned operations, the sub-pixel circuit SPC may include circuit elements, for example, transistors and one or more capacitors.

The transistors of the sub-pixel circuit SPC may include P-type transistors and/or N-type transistors. The transistors of the sub-pixel circuit SPC may include a metal oxide silicon field effect transistor (MOSFET). The transistors of the sub-pixel circuit SPC may include an amorphous silicon semiconductor, a monocrystalline silicon semiconductor, a polycrystalline silicon semiconductor, an oxide semiconductor, and/or the like.

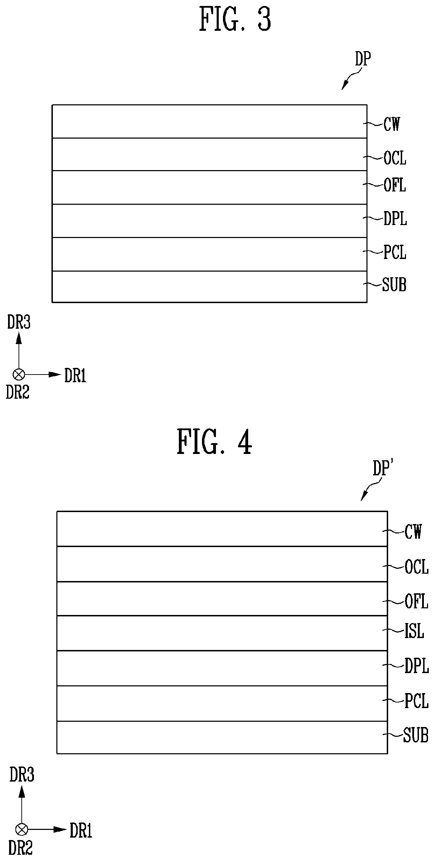

FIG. 3 is a sectional view illustrating the display panel of FIG. 1.

Referring to FIG. 3, a display panel DP may include a substrate SUB, and a pixel circuit layer PCL, a display element layer DPL, an optical function layer OFL, an overcoat layer OCL, and a cover window CW that are sequentially stacked on the substrate SUB in a third direction DR3 that intersects the first and second directions DR1 and DR2.

The substrate SUB may be made of insulating material such as glass or resin. For example, the substrate SUB may include a glass or polyimide substrate, or may include a silicon wafer substrate formed through a semiconductor process.

The substrate SUB may be made of material having flexibility so as to be bendable or foldable, and have a single-layer or multilayer structure. For instance, the material having flexibility may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, the embodiments are not limited to the aforementioned example.

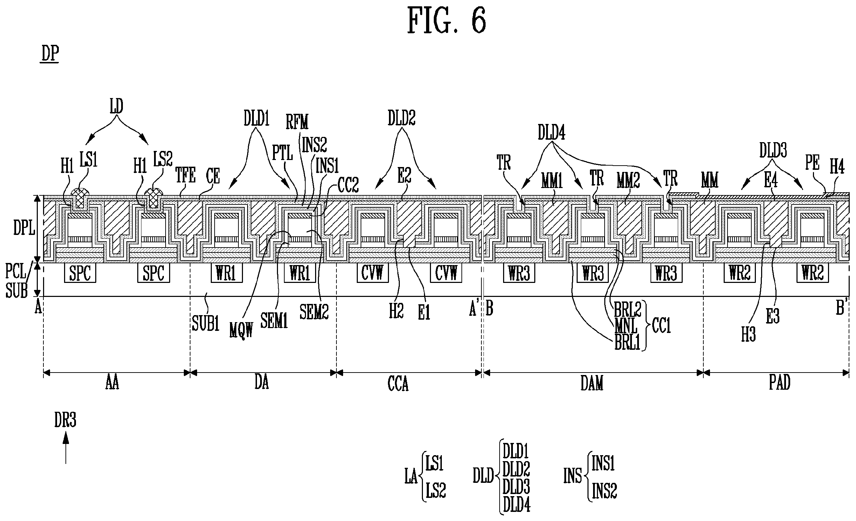

The pixel circuit layer PCL may be disposed on the substrate SUB. The pixel circuit layer PCL may include insulating layers, semiconductor patterns and conductive patterns (e.g., CVW, WR1, WR2, and WR3 of FIG. 6) that are disposed between the insulating layers. The conductive patterns of the pixel circuit layer PCL may function as circuit elements, lines, or the like.

The circuit elements of the pixel circuit layer PCL may include the respective sub-pixel circuits SPC (refer to FIG. 2) for each of the sub-pixels SP of FIG. 1. In other words, the circuit elements of the pixel circuit layer PCL may include transistors and one or more capacitors of the sub-pixel circuit SPC.

The lines of the pixel circuit layer PCL may include lines connected to each of the sub-pixels SP. The lines of the pixel circuit layer PCL may include various signal lines and/or voltage lines needed to drive the display element layer DPL.

The display element layer DPL may be disposed on the pixel circuit layer PCL. The display element layer DPL may include light emitting elements (hereinafter, refer to LD in FIG. 6) of the sub-pixels SPX.

The optical function layer OFL may be disposed on the display element layer DPL. The optical function layer OFL may include a color filter layer (not illustrated) and a lens array (refer to LA in FIG. 6).

The color filter layer may be disposed between the display element layer DPL and the lens array LA. The color filter layer may be configured to selectively output light in a wavelength range or color corresponding to each sub-pixel SP by filtering light emitted from the light emitting elements LD. The color filter layer may include color filters (not illustrated) that respectively correspond to the sub-pixels SP. Each of the color filters allows light within a wavelength range corresponding to the related sub-pixel SP to pass therethrough.

For example, a color filter corresponding to any one sub-pixel SP allows light in a red color to pass therethrough, a color filter corresponding to another sub-pixel SP allows light in a green color to pass therethrough, and a color filter corresponding to another sub-pixel SP allows light in a blue color to pass therethrough. Depending on light emitted from the light emitting element LD of each sub-pixel SP, at least some of the color filters may be omitted.

The lens array LA may be disposed on the color filter layer. The lens array LA may include lenses (refer to LS1 and LS2 in FIG. 6) that respectively correspond to the sub-pixels SP. Each of the lenses LS1 and LS2 may output and direct light emitted from the light emitting element LD along an intended path, thus enhancing the light output efficiency.

The lens array LA may have a relatively high refractive index. For example, the lens array LA may have a higher refractive index than the overcoat layer OCL. The lenses LS1 and LS2 may include organic material or acrylic material. However, the material constituting the lenses LS1 and LS2 is not limited to the foregoing example.

The overcoat layer OCL may be disposed on the optical function layer OFL. In other words, the overcoat layer OCL may cover the optical function layer OFL, the display element layer DPL, and the pixel circuit layer PCL. The overcoat layer OCL may include various materials suitable for protecting underlying layers from foreign substances such as dust, water, or the like. For example, the overcoat layer OCL may include at least one of an inorganic insulating layer and an organic insulating layer. For example, the overcoat layer OCL may include epoxy, but the embodiments are not limited thereto. The overcoat layer OCL may have a lower refractive index than the lens array LA.

The cover window CW may be disposed on the overcoat layer OC. The cover window CW may protect underlying layers. The cover window CW may have a higher refractive index than the overcoat layer OCL. The cover window CW may include glass, but it is not limited thereto. For example, the cover window CW may be an encapsulation glass layer configured to protect components disposed thereunder. In other embodiments, the cover window CW may be omitted.

FIG. 4 is a sectional view illustrating the display panel of FIG. 1.

Referring to FIG. 4, a display panel DP' may include a substrate SUB, a pixel circuit layer PCL, a display element layer DPL, an input sensing layer ISL, an optical function layer OFL, an overcoat layer OCL, and a cover window CW. The substrate SUB, the pixel circuit layer PCL, the display element layer DPL, the optical function layer OFL, the overcoat layer OCL, and the cover window CW may be respectively configured in the same manner as the substrate SUB, the pixel circuit layer PCL, the display element layer DPL, the optical function layer OFL, the overcoat layer OCL, and the cover window CW described with reference to FIG. 3. Hereinafter, redundant descriptions will be omitted.

The input sensing layer ISL may sense a user's input on a top surface (or display surface) of the display panel DP'. The input sensing layer ISL may include components suitable for sensing an external object such as the hand of the user, a pen, or the like. For example, the input sensing layer ISL may include touch electrodes.

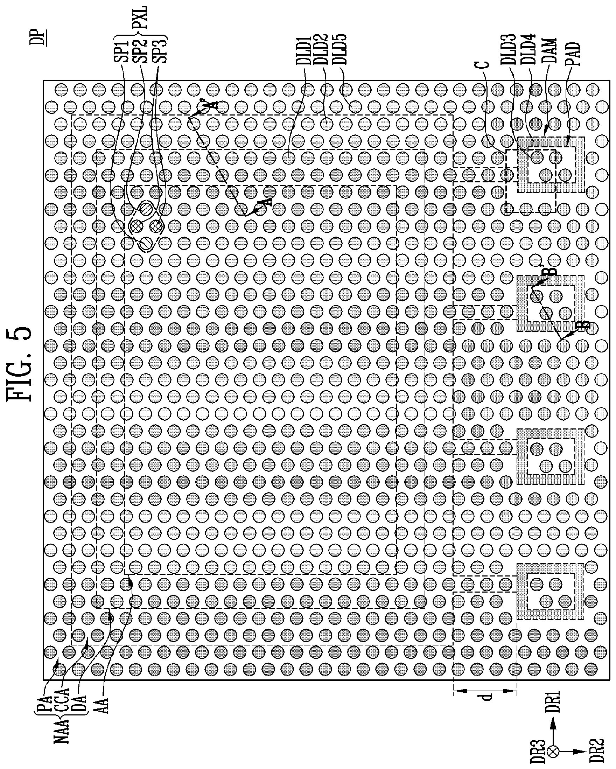

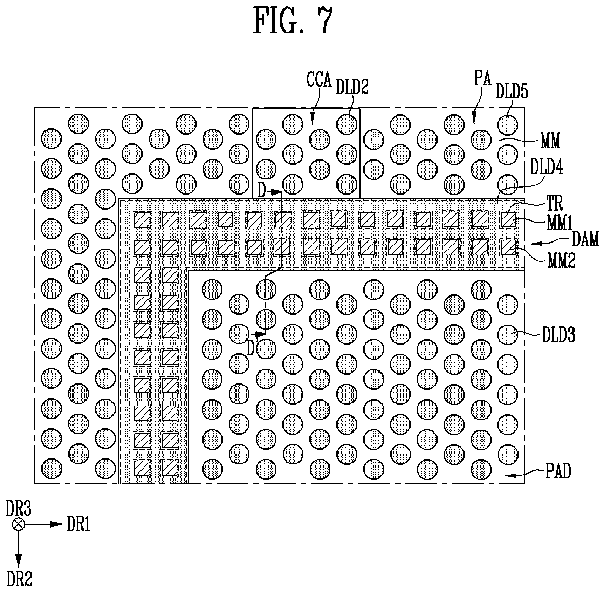

FIG. 5 is a plan view illustrating detailed components of the display panel illustrated in FIG. 1. FIG. 6 is a sectional view taken along a line A-A' and a line B-B' of FIG. 5. FIG. 7 is an enlarged plan view illustrating area C of FIG. 5.

In FIGS. 5 to 7, the display device DD is described primarily as a micro light emitting diode display device (or a micro-LED display device) that includes a micro light emitting diode (or a micro-LD) as the light emitting element LD. However, it is not limited to the foregoing example.

Furthermore, in FIGS. 5 to 7, the display device DD is described primarily as a light emitting diode on silicon (LEDos) device in which light emitting diodes are disposed on a semiconductor circuit substrate formed through a semiconductor process. However, it is not limited thereto.

The display device DD may be applied to wearable devices including watches, smart glasses, electronic devices in automotive applications, and various electronic devices such as a tablet PC, a television, a smart phone, and a notebook computer, but is not limited thereto. The display device DD may also be applied to a transparent display device configured to allow light transmission.

Hereinafter, in FIGS. 5 to 7, a first direction DR1 refers to a horizontal direction of the display panel DP, a second direction DR2 refers to a vertical direction of the display panel DP, and a third direction DR3 refers to a thickness direction of the display panel DP. In this case, "left," "right," "upper," and "lower" may refer to directions when the display panel DP is viewed in a plan view. For example, the term "right side" may mean one side in the first direction DR1, while the term "left side" may mean the other side in the first direction DR1. Likewise, the term "upper side" may mean one side in the second direction DR2, while the term "lower side" may mean the other side in the second direction DR2. In addition, the term "top" refers to one side in the third direction DR3, and the term "bottom" refers to the other side in the third direction DR3.

Referring to FIG. 5, the display device DD may include a display panel DP including a display area AA (or an active area) and a non-display area NAA (or a non-active area).

The display panel DP may have a rectangular planar shape with sides extending in the first direction DR1 and the second direction DR2. Here, the planar shape of the display panel DP is not limited to the aforementioned example, and may have other polygonal shapes, circular, elliptical, or amorphous shapes beyond the rectangular shape.

The display panel DP may have a planar display surface, or may have a display surface that is at least partially rounded. The display panel DP may be bendable, foldable, or rollable. In such cases, the display panel DP and/or a substrate of the display panel DP may include materials having flexible properties.

The display area AA may be an area which displays an image, and the non-display area NAA may be an area which does not display an image. The planar shape of the display area AA may follow the planar shape of the display panel DP. The display area AA may be disposed in a central area of the display panel DP, but the present disclosure is not limited thereto. For example, the display area AA may be disposed in any area in the display panel DP depending on the intended function of the display device DD.

The display area AA may have various shapes. The display area AA may have a closed-loop shape, including linear and/or curved sides. For example, the display area AA may have shapes such as a polygon, a circle, a semicircle, and an ellipse.

The display area AA of the display panel DP includes a plurality of sub-pixels SP. The sub-pixel SP may be divided into first to third sub-pixels SP1, SP2, and SP3. Hereinafter, when arbitrarily referring to at least one of the first to third sub-pixels SP1, SP2, and SP3, or collectively referring to two or more types of pixels, the term "sub-pixel SP" or "sub-pixels SP" will be used.

Although FIG. 5 illustrates that each of the pixels PXL includes one first sub-pixel SP1, one second sub-pixel SP2, and two third sub-pixels SP3, embodiments of the present disclosure are not limited thereto. Hereinafter, for convenience of descriptions, it is assumed that, as shown in the drawings, each pixel PXL includes one first sub-pixel SP1, one second sub-pixel SP2, and two third sub-pixels SP3. Furthermore, although each of the first to third sub-pixels SP1, SP2, and SP3 has a circular planar shape, they are not limited thereto.

The sub-pixels SP may be regularly arranged in the first direction DR1 and the second direction DR2 in a stripe or PENTILE^{™} arrangement structure. The arrangement structure of the sub-pixels SP is not limited thereto, and the sub-pixels SP may be arranged in the display area AA in various structures and/or schemes.

For example, the sub-pixels SP may be arranged in the display area AA in a zigzag form in the first direction DR1 and the second direction DR2. In detail, in one pixel PXL, the first sub-pixel SP1 and the second sub-pixel SP2 may be disposed in parallel to each other in the first direction DR1, and the two third sub-pixels SP3 may be spaced apart from each other in the second direction DR2 and disposed in space between the first sub-pixel SP1 and the second sub-pixel SP2.

For instance, in FIG. 5, the first sub-pixel SP1, the second sub-pixel SP2, and the third sub-pixels SP3 are arranged in a rhombus shape in one pixel PXL, but they are not limited thereto. The arrangement of the sub-pixels SP may vary.

Each of the first to third sub-pixels SP1, SP2, and SP3 may generate light of one among various colors such as red, green, blue, cyan, magenta, and yellow. Hereinafter, for clear and concise description, it is assumed that the first sub-pixel SP1 is configured to generate light in red, the second color pixel SP2 is configured to generate light in blue, and the third sub-pixel SP3 is configured to generate light in green.

Each of the first to third sub-pixels SP1, SP2, and SP3 may include at least one light emitting element (refer to LD of FIG. 6) configured to generate light. The light emitting elements LD of the first to third sub-pixels SP1, SP2, and SP3 may generate light in the same color. For example, the light emitting elements LD of the first to third sub-pixels SP1, SP2, and SP3 may generate light in blue. The light emitting elements LD of the first to third sub-pixels SP1, SP2, and SP3 may generate light of different colors. For example, the light emitting elements LD of the first to third sub-pixels SP1, SP2, and SP3 may generate light in red, green, and blue.

The non-display area NAA may be disposed to surround a peripheral portion of the display area AA. Components for controlling the sub-pixels SP may be disposed in the non-display area NAA. Lines connected to the sub-pixels SP, for example, the first to m-th gate lines GL1 to GLm, the first to n-th data lines DL1 to DLn, the power lines PL, and the pixel control lines PXCL of FIG. 1, may be disposed in the non-display area NAA.

At least one of the gate driver 120, the data driver 130, the voltage generator 140, and the controller 150 of FIG. 1 may be disposed in the non-display area NAA. The gate driver 120 may be disposed in the non-display area NAA. In such a case, the data driver 130, the voltage generator 140, and the controller 150 may be implemented as the driver integrated circuit DIC of FIG. 1 that is separate from the display panel DP. The driver integrated circuit DIC may be connected to a pad area PAD disposed in the non-display area NAA. The gate driver 120 along with the data driver 130, the voltage generator 140, and the controller 150 may be implemented as a single integrated circuit IC that is separate from the display panel DP.

In detail, the non-display area NAA may include a dummy area DA, a cathode contact area CCA, the pad area PAD, a dam area DAM, and a peripheral area PA.

The dummy area DA may be formed outside the display area AA and surround the display area AA. A plurality of first dummy light emitting elements DLD1 may be disposed in the dummy area DA. In detail, the first dummy light emitting elements DLD1 may be arranged on the entire area of the dummy area DA in the same pattern as the sub-pixels SP arranged in the display area AA. Furthermore, the first dummy light emitting elements DLD1 may include substantially the same material as the light emitting element LD.

Due to the structure in which the dummy area DA including the first dummy light emitting elements DLD1 surrounds the display area AA, the process uniformity of the display area AA may be improved.

The cathode contact area CCA may be formed outside the dummy area DA and surround the dummy area DA. A plurality of second dummy light emitting elements DLD2 may be disposed in the cathode contact area CCA. In detail, the second dummy light emitting elements DLD2 may be arranged on the entire area of the cathode contact area CCA in the same pattern as the sub-pixels SP arranged in the display area AA. For example, the light emitting elements LD disposed in the display area AA, the first dummy light emitting elements DLD1 disposed in the dummy area DA, and the second dummy light emitting elements DLD2 disposed in the cathode contact area CCA may be arranged on the display panel DP in the same pattern. Furthermore, the second dummy light emitting elements DLD2 may include substantially the same material as the light emitting elements LD and the first dummy light emitting elements DLD1.

The cathode contact area CCA may be electrically connected to the pad area PAD through conductive connection components formed in the pixel circuit layer PCL (e.g., a second connection line WR2, a third connection line WR3, and a common voltage line CVW of FIG. 6) so as to transmit a common voltage signal applied through the pad area PAD to the dummy area DA and the display area AA. The mechanism by which the common voltage signal is applied through the pad area PAD and transmitted to the display area AA via the cathode contact area CCA and the dummy area DA, along with resulting actions and effects, will be described in more detail with reference to FIG. 6.

The pad area PAD may be spaced apart from the cathode contact area CCA by a certain distance d. The pad area PAD may be disposed on one side of the display panel DP to be spaced apart from some areas defined by the display area AA, the dummy area DA, and the cathode contact area CCA on the display panel DP. A plurality of third dummy light emitting elements DLD3 may be disposed in the pad area PAD. In detail, the third dummy light emitting elements DLD3 may be arranged on the entire area of the pad area PAD in the same pattern as the sub-pixels SP arranged in the display area AA. For example, the light emitting elements LD disposed in the display area AA, the first dummy light emitting elements DLD1 disposed in the dummy area DA, the second dummy light emitting elements DLD2 disposed in the cathode contact area CCA, and the third dummy light emitting elements DLD3 disposed in the pad area PAD may be arranged on the display panel DP in the same pattern. Furthermore, the third dummy light emitting elements DLD3 may include substantially the same material as the light emitting elements LD, the first dummy light emitting elements DLD1, and the second dummy light emitting elements DLD2.

The pad area PAD may be electrically connected to a circuit board (not shown) that is separate from the display panel DP to receive electrical signals for driving the display device DD from the circuit board. For example, the circuit board may include the driver integrated circuit DIC described above with reference to FIG. 1 and other modifications thereof. Furthermore, electrical signals applied to the pad area PAD may include a gate control signal GCS, a gate signal, a data signal, a pixel control signal, a first power voltage, and/or a second power voltage that are described above with reference to FIG. 1. The mechanism by which the electrical signals applied from the circuit board to the pad area PAD are transmitted to the display area AA via the dam area DA, the cathode contact area CCA, and the dummy area DA, along with resulting actions and effects, will be described in more detail with reference to FIG. 6.

The dam area DAM may be formed outside the pad area PAD and surround the pad area PAD. One or more fourth dummy light emitting elements DLD4 may be disposed in the dam area DAM. In detail, the fourth dummy light emitting elements LDL4 may extend in a closed-loop shape to surround the pad area PAD along the dam area DAM. Furthermore, the fourth dummy light emitting elements DLD4 may include substantially the same material as the light emitting elements LD, the first dummy light emitting elements DLD1, the second dummy light emitting elements DLD2, and the third dummy light emitting elements DLD3.

The dam area DAM may electrically insulate the cathode contact area CCA and the pad area PAD from each other in the display element layer DPL. Due to the aforementioned structure, an electrical signal applied to the pad area PAD may be transmitted to the cathode contact area CCA through the pixel circuit layer PCL. The mechanism by which electrical signals applied from the circuit board to the pad area PAD are transmitted to the display area AA via the dam area DA, the cathode contact area CCA, and the dummy area DA, along with resulting actions and effects, will be described in more detail with reference to FIG. 6.

The peripheral area PA may not correspond to any of the display area AA, the dummy area DA, the cathode contact area CCA, the pad area PAD, and the dam area DAM on the display panel DP. A plurality of fifth dummy light emitting elements DLD5 may be disposed in the peripheral area PA. In detail, the fifth dummy light emitting elements DLD5 may be arranged on the entire area of the peripheral area PA in the same pattern as the sub-pixels SP arranged in the display area AA. For example, the light emitting elements LD disposed in the display area AA, the first dummy light emitting elements DLD1 disposed in the dummy area DA, the second dummy light emitting elements DLD2 disposed in the cathode contact area CCA, and the third dummy light emitting elements DLD3 disposed in the pad area PAD may be arranged on the display panel DP in the same pattern. Furthermore, the fifth dummy light emitting elements DLD5 may include substantially the same material as the light emitting elements LD, the first dummy light emitting elements DLD1, the second dummy light emitting elements DLD2, and the third dummy light emitting elements DLD3.

Hereinafter, the term "dummy light emitting element DLD" or "dummy light emitting elements DLD" will be used to arbitrarily designate at least one dummy light emitting element among individual dummy light emitting elements such as the first to fifth dummy light emitting elements DLD1, DLD2, DLD3, DLD4, and DLD5, or collectively designate two or more types of dummy light emitting elements.

Referring to FIG. 6, the display panel DP may include a substrate SUB, a pixel circuit layer PCL disposed on the substrate SUB and including a plurality of sub-pixel circuits SPC disposed in the display area AA, a plurality of first conductive connectors CC1 disposed on the pixel circuit layer PCL, and a display element layer DPL disposed on the first conductive connectors CC1.

The display element layer DPL may include a plurality of light emitting elements LD disposed in the display area AA and electrically connected to the sub-pixel circuits SPC through some of the first conductive connectors CC1 to emit light in response to signals applied thereto from the sub-pixel circuits SPC, and a plurality of dummy light emitting elements DLD disposed in the non-display area NAA. The dummy light emitting elements DLD may include the same material as the light emitting elements LD.

The substrate SUB, the sub-pixel circuit SPC, and the display element layer DPL may be respectively configured in the same manners as the substrate SUB, the sub-pixel circuit SPC, and the display element layer DPL described with reference to FIGS. 2 and 3. Hereinafter, redundant descriptions will be omitted.

Each of the light emitting elements LD and dummy light emitting elements DLD may include a first semiconductor layer SEM1 disposed on any one of the first conductive connectors CC1, an active layer MQW disposed on the first semiconductor layer SEM1, a second semiconductor layer SEM2 disposed on the active layer MQW, and a second conductive connector CC2 disposed on the second semiconductor layer SEM2.

The first semiconductor layer SEM1, the active layer MQW, the second semiconductor layer SEM2, and the second conductive connector CC2 that form the light emitting element LD or the dummy light emitting element DLD may be sequentially stacked in the thickness direction DR3 of the substrate SUB.

Some of the first conductive connectors CC1 may be brought into contact with the light emitting elements LD and connected to the sub-pixel circuits SPC. Some other of the first conductive connectors CC1 may be brought into contact with the dummy light emitting elements DLD and separated from the sub-pixel circuits SPC.

Here, the expression "some other of the first conductive connectors CC1 may be brought into contact with the dummy light emitting elements DLD and separated from the sub-pixel circuits SPC" may mean that the first conductive connectors CC1 positioned in the non-display area NAA are physically positioned in a different space from the sub-pixel circuits SPC positioned in the display area AA. The foregoing may mean that some of the first conductive connectors CC1 positioned in the non-display area NAA may be connected to the sub-pixel circuits SPC through intermediate media such as the first to third connection lines WR1, WR2, and WR3 and the common voltage line CVW. Here, even in such cases, as will be described later, unlike the light emitting elements LD, the dummy light emitting elements DLD cannot emit light because the dummy light emitting elements DLD are insulated from the cathode electrode CE even if electrical signals are applied from the sub-pixel circuits SPC to the dummy light emitting elements DLD through the first conductive connectors CC1.

In detail, with regard to the first conductive connectors CC1 disposed in the dummy area DA, top surfaces thereof may contact the first dummy light emitting elements DLD1, and bottom surfaces thereof may contact the first connection line WR1. The first connection line WR1 may transmit various electrical signals for driving the display panel DP to other components, and may be omitted in some implementations.

Furthermore, with regard to the first conductive connectors CC1 disposed in the cathode contact area CCA, top surfaces thereof may contact the second dummy light emitting elements DLD2 and a metal mesh MM, and bottom surfaces thereof may contact the common voltage lines CVW. The first conductive connectors CC1 disposed in the cathode contact area CCA may receive a common voltage signal from the common voltage lines CVW and transmit the common voltage signal to the second dummy light emitting elements DLD2 and the metal mesh MM disposed in the cathode contact area CCA.

Furthermore, with regard to the first conductive connectors CC1 disposed in the pad area PAD, top surfaces thereof may contact the third dummy light emitting elements DLD3 and the metal mesh MM, and bottom surfaces thereof may contact the second connection line WR2. The first conductive connectors CC1 disposed in the pad area PAD may receive various electrical signals for driving the display panel DP from the metal mesh MM and transmit the electrical signals to the second connection line WR2.

In detail, the second connection line WR2 may transmit various electrical signals applied to the pad electrode PE for driving the display panel DP to the sub-pixel circuit SPC and the common voltage line CVW through other conductive connection components (e.g., the first connection line WR1 and the third connection lines WR3) that are formed in the pixel circuit layer PCL. These signals, such as an anode signal or a cathode signal, are used to drive the display panel DP.

Furthermore, with regard to the first conductive connectors CC1 disposed in the dam area DAM, top surfaces thereof may contact the fourth dummy light emitting elements DLD4, and bottom surfaces thereof may contact the third connection lines WR3. The third connection line WR3 may be electrically connected to other conductive connection components disposed in the pixel circuit layer PCL to transmit various electrical signals for driving the display panel DP to other components, but may be omitted in some implementations.

The first conductive connector CC1, the first semiconductor layer SEM1, the active layer MQW, the second semiconductor layer SEM2, and the second conductive connector CC2 may be patterned through the same process across the display area AA, the dummy area DA, the cathode contact area CCA, the dam area DAM, the pad area PAD, and the peripheral area PA. Taken along the thickness direction DR3 of the substrate SUB, the cross-section of any one of the first dummy light emitting elements DLD1, the second dummy light emitting elements DLD2, the third dummy light emitting elements DLD3, and the fourth dummy light emitting element DLD4 may have the same cross-sectional shape as any one of the light emitting elements LD taken along the thickness direction DR3 of the substrate SUB.

The fourth dummy light emitting element DLD4 has the same cross-sectional shape as the light emitting elements LD and the first to third dummy light emitting elements DLD1, DLD2, and DLD3. However, the fourth dummy light emitting element DLD4 may have a rectangular shape extending in a closed-loop shape along the dam area DAM unlike the light emitting elements LD and the first to third dummy light emitting elements DLD1, DLD2, and DLD3 that are distributed in a dotted shape on the display panel DP.

The first conductive connector CC1 may include a first barrier layer BRL1, a main layer MNL, and a second barrier layer BRL2. The barrier layer BRL1, the main layer MNL, and the second barrier layer BRL2 may be sequentially stacked on the pixel circuit layer PCL in the thickness direction DR3 of the display panel DP.

The main layer MNL may be formed of an alloy of a first metal material and a second metal material having a melting point lower than that of the first metal material. In other words, the main layer MNL may be formed of an IMC alloy provided through a process of infiltrating the second metal material having a relatively low melting point into the first metal material in a molten state. For example, any one of gold (Au), silver (Ag), and copper (Cu) may be selected as the first metal material having a relatively high melting point. A metal having a melting point lower than that of the first metal material may be selected as the second metal material. For example, tin (Sn) may be selected as the second metal material. In other words, the main layer MNL may be formed of an IMC alloy corresponding to any one of AuSn, AgSn, and CuSn.

Each of the first barrier layer BRL1 and the second barrier layer BRL2 may be formed of a material capable of preventing diffusion of the main layer MNL. For example, titanium (Ti) may be selected as the material of each of the first barrier layer BRL1 and the second barrier layer BRL2.

The first conductive connector CC1 may function as a connection electrode or an anode electrode configured to apply an emission signal to the light emitting element LD. The first conductive connector CC1 may be an ohmic connection electrode, but is not limited thereto, and may be a Schottky connection electrode in some examples.

The first semiconductor layer SEM1 may be disposed on any one of the first conductive connectors CC1. The first semiconductor layer SEM1 may be a p-type semiconductor, and may include a semiconductor material having a chemical formula of AlxGayIn1-x-yN (0 ≤ x ≤ 1, 0 ≤ y ≤ 1, 0 ≤ x+y ≤ 1). For example, the semiconductor material may include one or more of p-type doped AlGaInN, GaN, AlGaN, InGaN, AIN and InN. The first semiconductor layer SEM1 may be doped with a p-type dopant. The p-type dopant may be Mg, Zn, Ca, Se, Ba, or the like. For example, the first semiconductor layer SEM1 may include p-GaN doped with p-type Mg.

The active layer MQW may be disposed on the first semiconductor layer SEM1. The active layer MQW may emit light by combination of electron-hole pairs in response to electric signals applied through the first semiconductor layer SEM1 and the second semiconductor layer SEM2. The active layer MQW may emit light in any one of a blue wavelength band, a green wavelength band, and a red wavelength band.

The active layer MQW may include material having a single or multiple quantum well structure. When the active layer MQW includes material having a multiple quantum well structure, the active layer MQW may have a structure formed by alternately stacking a plurality of well layers and a plurality of barrier layers. Here, although the well layer may be formed of InGaN and the barrier layer may be formed of GaN or AlGaN, the present disclosure is not limited thereto.

In another example, the active layer MQW may have a structure formed by alternately stacking semiconductor materials having large band gap energy and semiconductor materials having small band gap energy, and may include group-III to -V semiconductor materials depending on the wavelength band of light to be emitted. In an embodiment, when indium (In) is included in the active layer MQW, the color of light emitted may vary depending on the content of indium. For example, if the indium content is in a range from approximately 10% to approximately 15%, light in the blue wavelength band may be emitted. If the indium content is in a range from approximately 20% to approximately 25%, light in the green wavelength band may be emitted. If the indium content is in a range from approximately 30% to approximately 45%, light in the red wavelength band may be emitted.

Although not illustrated in the drawings, an electron blocking layer (EBL) may be interposed between the first semiconductor layer SEM and the active layer MQW. The EBL may be a layer provided to mitigate or prevent an excessive number of electrons from flowing into the active layer MQW. For example, the EBL may include p-AlGaN doped with p-type magnesium (Mg). The EBL may be omitted, as shown in FIG. 6.

The second semiconductor layer SEM2 may be disposed on the active layer MQW. The second semiconductor layer SEM2 may be formed of an n-type semiconductor. The second semiconductor layer SEM2 may include semiconductor material having a chemical formula of AlxGayIn1-x-yN (0 ≤ x ≤ 1, 0 ≤ y ≤ 1, 0 ≤ x+y ≤ 1). For example, the second semiconductor layer SEM2 may include any one or more of n-type doped AlGaInN, GaN, AlGaN, InGaN, AIN and InN.

The second semiconductor layer SEM2 may be doped with an n-type dopant. The n-type dopant may be silicon (Si), germanium (Ge), tin (Sn), or the like. For example, the second semiconductor layer SEM2 may be n-GaN doped with n-type Si. The second semiconductor layer SEM2 may transmit, to the light emitting elements LD, a common voltage signal applied through the cathode electrode CE.

Although not illustrated in the drawings, a superlattice layer (SLT) may be interposed between the active layer MQW and the second semiconductor layer SEM2. The SLT may mitigate stress between the second semiconductor layer SEM2 and the active layer MQW. For example, the SLT may include InGaN or GaN. In the same manner as the EBL, the SLT may also be omitted, as shown in FIG. 6.

The second conductive connector CC2 may be disposed on the second semiconductor layer SEM2. The second conductive connector CC2 may be formed of substantially transparent or translucent conductive material to satisfy a certain light transmittance. The second conductive connector CC2 may be a common layer formed in common on all of the light emitting elements LD. The second conductive connector CC2 may be a cathode electrode. The second conductive connectors CC2 may be formed of various transparent conductive oxide (TCO) such as indium tin oxide (ITO), indium zinc oxide (IZO), zinc oxide (ZnO), indium gallium zinc oxide (IGZO), or indium tin zinc oxide (ITZO), or semi-transmissive conductive material such as magnesium (Mg), silver (Ag), or an alloy of magnesium (Mg) and silver (Ag). When the second conductive connector CC2 is formed of semi-transmissive conductive material, the light output efficiency may be enhanced by micro cavities. Here, the material of the second conductive connector CC2 is not limited thereto.

Hereinafter, other components of the display panel DP disposed on the light emitting elements LD and the dummy light emitting elements DLD will be described in more detail.

The display element layer DPL may further include an insulating layer INS, a reflective layer RFM, a protective layer PTL, a metal mesh MM, a cathode electrode CE, and a thin-film encapsulation layer TFE. As described in detail below, the insulating layer INS, the reflective layer RFM, the protective layer PTL, the metal mesh MM, the cathode electrode CE, and the thin-film encapsulation layer TFE may be formed across the entire surface of the display panel DP, including the display area AA, the dummy area DA, the cathode contact area CCA, the dam area DAM, the pad area PAD, and the peripheral area PA, rather than being restricted to a specific area or areas of the display panel DP. However, it should be noted that some components may have shapes resulting from etching and removing portions thereof in specific areas.

The insulating layer INS may cover at least portions of side surfaces and top surfaces of the first conductive connectors CC1, the light emitting elements LD, and the dummy light emitting elements DLD. The insulating layer INS may protect components provided under the insulating layer INS such as the first conductive connectors CC1, the light emitting elements LD, and the dummy light emitting elements DLD1, DLD2, DLD3, and DLD4 from external water, moisture, and the like. In detail, the insulating layer INS may include a first insulating layer INS1 and a second insulating layer INS2.

The first insulating layer INS1 may cover portions of the top surfaces of the first conductive connectors CC1, and at least portions of the side surfaces and top surfaces of the light emitting elements DLD and the dummy light emitting elements DLD. The first insulating layer INS1 may prevent side wall defects of the light emitting elements LD from occurring during an etching process in manufacturing the display device DD, which will be described later, thereby reducing non-emissive defects.

The first insulating layer INS1 may be formed of an inorganic insulating layer including inorganic material. For example, the first insulating layer INS1 may include at least one of silicon nitride (SiNₓ), silicon oxide (SiOₓ), silicon oxynitride (SiOₓN_{y}), and metal oxide such as aluminum oxide (AlOₓ). However, the material of the first insulating layer INS1 is not limited to the foregoing. For instance, the first insulating layer INS1 may include an organic insulating layer including organic material.

The second insulating layer INS2 may be disposed on the first insulating layer INS1, and may cover portions of the top surfaces and the side surfaces of the light emitting elements LD and the dummy light emitting elements DLD together with the first insulating layer INS1, while also covering a portion of the top surface and the side surface of the first conductive connector CC1. The second insulating layer INS2 may protect components provided under the second insulating layer INS2 such as the first insulating layer INS1, the second conductive connector CC2, the second semiconductor layer SEM2, the active layer MQW, the first semiconductor layer SEM1, and the first conductive connector CC1 from external water, moisture, and the like.

The second insulating layer INS2 may be formed of an inorganic insulating layer including inorganic material. For example, the second insulating layer INS2 may include at least one of silicon nitride (SiNₓ), silicon oxide (SiOₓ), silicon oxynitride (SiOₓN_{y}), and metal oxide such as aluminum oxide (AlOₓ). However, the material of the second insulating layer INS2 is not limited to the foregoing. For instance, the second insulating layer INS2 may include an organic insulating layer including organic material.

As such, due to the structure in which the insulating layer INS including the first insulating layer INS1 and the second insulating layer INS2 covers portions of the top surfaces and the side surfaces of the light emitting elements LD and the dummy light emitting elements DLD and portions of the top surfaces and the side surfaces of the first conductive connector CC1, the light emitting elements LD that are adjacent to each other may be insulated from each other.

The reflective layer RFM may be disposed on the insulating layer INS, and may include conductive materials suitable for reflecting light such as aluminum (Al). The reflective layer RFM may have an opening on the light emitting elements LD which extends along the third direction DR3. Due to the foregoing structure, light emitted from the light emitting elements LD may be guided in the third direction DR3. Consequently, the light output efficiency of the light emitting elements LD may be enhanced. The reflective layer RFM may include at least one of aluminum (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from among the aforementioned materials. However, it is not limited thereto.

The protective layer PTL may be disposed on the reflective layer RFM. The protective layer PTL may protect components provided under the protective layer PTL such as the reflective layer RFM, the second insulating layer INS2, the first insulating layer INS1, the second conductive connector CC2, the second semiconductor layer SEM2, the active layer MQW, the first semiconductor layer SEM1, and the first conductive connector CC1 from external water, moisture, and the like.

The protective layer PTL may be formed of an inorganic insulating layer including inorganic material. For example, the protective layer PTL may include at least one of silicon nitride (SiNₓ), silicon oxide (SiOₓ), silicon oxynitride (SiOₓN_{y}), and metal oxide such as aluminum oxide (AlOₓ). However, the material of the protective layer PTL is not limited to the aforementioned examples. For instance, the protective layer PTL may include an organic insulating layer including organic material.

The metal mesh MM may be disposed on the protective layer PTL in space between the light emitting elements LD adjacent to each other and in space between the dummy light emitting elements DLD adjacent to each other, while allowing a portion of a top surface of the protective layer PTL to be exposed.

The insulating layer INS, the reflective layer RFM, and the protective layer PTL may include a plurality of first contact holes H1 which extends to at least portions of the top surfaces of the light emitting elements LD, and a trench TR which extends to portions of the top surfaces of the fourth dummy light emitting elements DLD.

In detail, the first contact holes H1 may extend to the top surfaces of the second conductive connectors CC2 of the light emitting elements LD positioned in the display area AA. Furthermore, the trench TR may extend to the top surfaces of the second conductive connectors CC2 of the fourth dummy light emitting elements DLD4 positioned in the dam area DAM.

The cathode electrode CE may be disposed on the protective layer PTL and the metal mesh MM. Furthermore, the cathode electrode CE may be electrically connected to the top surfaces of the second conductive connectors CC2 of the light emitting elements LD through the first contact holes H1. As such, the top surfaces of the light emitting elements LD are electrically connected to the cathode electrode CE, and the bottom surfaces of the light emitting elements LD are electrically connected to the first conductive connector CC1. As a result, the light emitting elements LD may emit light based on current flowing from the first conductive connector CC1 to the cathode electrode CE.

A portion of the cathode electrode CE that is formed in the cathode contact area CCA and another portion of the cathode electrode CE that is formed in the pad area PAD may be separated from each other with the trench TR interposed therebetween. In other words, the dam area DAM may insulate the portion of the cathode electrode CE that is formed in the cathode contact area CCA from the portion of the cathode electrode CE that is formed in the pad area PAD.

The thin-film encapsulation layer TFE may be disposed on the cathode electrode CE. The thin-film encapsulation layer TFE may include an inorganic insulating layer including inorganic material and/or an organic insulating layer including organic material. The inorganic insulating layer may include, for example, at least one of silicon oxide (SiOₓ), silicon nitride (SiNₓ), silicon oxynitride (SiOₓN_{y}), and metal oxide such as aluminum oxide (AlOₓ). The organic insulating layer may include, for example, at least one of acrylic resin, epoxy resin, phenolic resin, polyamide resin, polyimide resin, unsaturated polyester resin, poly-phenylene ether resin, poly-phenylene sulfide resin, and benzocyclobutene resin. The thin-film encapsulation layer TFE may be provided as a single-layer structure including organic or inorganic material, and may be provided as a multilayer structure formed by alternately stacking organic material and inorganic material. The thin-film encapsulation layer TFE may include various materials capable of functioning as a buffer to protect underlying layers thereof from external impact, or suitable for protecting the underlying layers from oxygen and foreign material such as dust or water. Hereinafter, for the sake of convenience in explanation, the following description will be based on the case where the thin-film encapsulation layer TFE is provided as a single-layer structure.

The lens array LA including a first lens LS1 and a second lens LS2 may be formed in a trench portion of the thin-film encapsulation material layer TFEM corresponding to the first contact hole H1 over the light emitting elements LD. The lens array LA may be formed as many as the number of light emitting elements LD to correspond to each of all light emitting elements LD formed in the display area AA.

The thin-film encapsulation layer TFE may contact the top surface of the second conductive connector CC2 of the fourth dummy light emitting element DLD4, positioned in the dam area DAM, through the trench TR. According to the foregoing structure, the side surface of the cathode electrode CE disposed in the dam area DAM may be covered with the thin-film encapsulation layer TFE on the fourth dummy light emitting element DLD4. Furthermore, the side surfaces of the protective layer PTL, the reflective layer RFM, the second insulating layer INS2, and the first insulating layer INS1 that are sequentially disposed under the cathode electrode CE may also be covered with the thin-film encapsulation layer TFE.

The insulating layer INS, the reflective layer RFM, and the protective layer PTL may include a plurality of second contact holes H2, in the cathode contact area CCA, that extend to at least portions of the top surfaces of the first conductive connectors CC1 contacting the second dummy light emitting elements DLD2, and a plurality of third contact holes H3, in the pad area PAD, that extends to at least portions of the top surfaces of the first conductive connectors CC1 contacting the third dummy light emitting elements DLD3.

A first end E1 of the metal mesh MM that is positioned in the cathode contact area CCA may be electrically connected to at least portions of the top surfaces of the first conductive connectors CC1 that are positioned in the cathode contact area CCA through the second contact holes H2. A second end E2 of the metal mesh MM that is positioned in the cathode contact area CCA may be electrically connected to the cathode electrode CE positioned in the cathode contact area CCA. According to the foregoing structure, an electrical signal applied through the common voltage line CVW may be transmitted to the cathode electrode CE through the first conductive connector CC1 and the metal mesh MM in the cathode contact area CCA.

As such, the electrical signal transmitted to the cathode electrode CE may be transmitted to the dummy area DA and the display area AA. When it comes to the dummy area DA, the first dummy light emitting element DLD1 is insulated from the cathode electrode CE by the insulating layer INS and the protective layer PTL. Hence, the electrical signal applied to the cathode electrode CE may not be transmitted to the first dummy light emitting element DLD1. Accordingly, the first dummy light emitting element DLD1 may not emit light.

Since the cathode electrode CE that is positioned in the display area AA is electrically connected to the second conductive connector CC2 of the light emitting element LD, the electrical signal applied to the cathode electrode CE in the cathode contact area CCA may be transmitted to the second conductive connector CC2 of the light emitting element LD via the dummy area DA. Consequently, the light emitting element LD may emit light based on a first electrical signal (e.g., an anode signal) applied to the sub-pixel circuit SPC and a second electrical signal (e.g., a cathode signal) provided from the cathode electrode CE.

A first end E3 of the metal mesh MM that is positioned in the pad area PAD may be electrically connected to at least portions of the top surfaces of the first conductive connectors CC1 that are positioned in the pad area PAD through the third contact holes H3. Furthermore, a second end E4 of the metal mesh MM that is positioned in the pad area PAD may be electrically connected to the cathode electrode CE positioned in the pad area PAD.

The thin-film encapsulation layer TFE may include a fourth contact hole H4 extending to a top surface of the cathode electrode CE that is positioned in the pad area PAD. The display element layer DPL may be disposed on the thin-film encapsulation layer TFE, and may further include a pad electrode PE electrically connected to the cathode electrode CE through the fourth contact hole H4.

As described above, the pad electrode PE may be electrically connected to the circuit board (e.g., the driver integrated circuit DIC) that is separate from the display panel PD. Hence, the pad electrode PE may receive various electrical signals for driving the display panel DP from the circuit board. Electrical signals applied to the pad electrode PE may be transmitted to the second connection line WR2 through underlying components of the display panel DP, such as the cathode electrode CE, the metal mesh MM and the first conductive connector CC1, electrically connected to the pad electrode PE.

Hereinafter, the dam area DAM and surrounding components thereof will be described in more detail with reference to FIGS. 6 and 7.

Referring to FIGS. 6 and 7, based on a plane defined in the first direction DR1 and the second direction DR2, the fourth dummy light emitting element DLD4 may have a closed-loop shape surrounding the pad area PAD. The fourth dummy light emitting element DLD4 may include a first semiconductor layer SEM1, an active layer MQW, a second semiconductor layer SEM2, and a second conductive connector CC2 in the same manner as the other dummy light emitting elements DLD. A cross-sectional shape of the fourth dummy light emitting element DLD4 may also be the same as that of the other dummy light emitting elements DLD.

As described above, the trench TR may extend to the top surface of the fourth dummy light emitting element DLD4, i.e., the top surfaces of the second conductive connectors CC2 positioned in the dam area DAM. The thin-film encapsulation layer TFE may be connected to the top surfaces of the second conductive connectors CC2 that are disposed in the dam area DAM through the trench TR. The thin-film encapsulation layer TFE that is positioned in the dam area DAM may fill the trench TR, thereby covering all side surfaces of the components between the second conductive connector CC2 and the thin-film encapsulation layer TFE. Furthermore, the side surfaces of the first conductive connectors CC1 that respectively contact the bottom surfaces of the fourth dummy light emitting elements DLD4 may be covered with the insulating layer INS and thus insulated from each other.

The fourth dummy light emitting element DLD4 may be formed in the dam area DAM in a mesh shape based on the plane defined in the first direction DR1 and the second direction DR2. In the dam area DAM, space not occupied by the fourth dummy light emitting element DLD4 may be filled with the metal mesh MM. For example, the metal mesh MM may be formed between the fourth dummy light emitting elements DLD4 adjacent to each other based on the first direction DR1 or the second direction DR2. FIG. 7 illustrates that two spaces where no fourth dummy light emitting element DLD4 is formed are provided based on the first direction DR1 or the second direction DR2. The metal mesh MM may include a first metal mesh MM1 and a second metal mesh MM2 that are respectively disposed in the two spaces. FIG. 6 may be understood as a sectional view taken along a line D-D' of FIG. 7.

As described above, the metal mesh MM may be a component distributed throughout the entire area of the display panel DP, and may function to electrically connect the first conductive connector CC1 and the cathode electrode CE in the cathode contact area CCA and the pad area PAD to each other. On the other hand, the metal mesh MM positioned in the dam area DAM may be insulated by the insulating layer INS interposed between the thin-film encapsulation layer TFE formed in the trench TR and the adjacent first conductive connector CC1.

For example, in order for an electrical signal to be transmitted from the pad area PAD to the cathode contact area CCA through the cathode electrode CE, all of the cathode electrodes CE, which are physically separated from each other by a total of three trenches TR, must be free of fabrication defects. In other words, if the trenches TR are not formed as designed during the fabrication process, it cause a failure to physically separate the cathode electrodes CE in the dam area DAM, and unintended current flow may occur in the display element layer DPL, which may potentially result in an electrical short-circuit.

A total of three trenches TR may be formed in the dam area DAM. According to the foregoing structure, even if a fabrication defect occurs in one trench TR, the remaining two trenches TR can still physically separate the cathode electrodes CE from each other, thus preventing an electrical short-circuit from occurring. However, the example mentioned above is merely illustrative, and is not limited thereto. Due to the aforementioned reasons, two or more trenches TR may be formed, but a structure in which one trench TR is formed as a structure for preventing electrical short-circuiting is not completely excluded from the present disclosure.

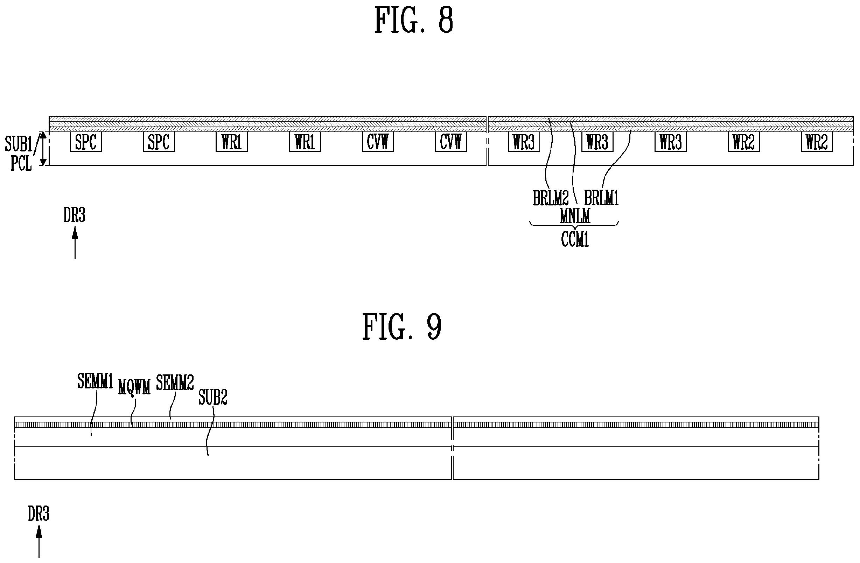

Hereinafter, a method of fabricating the display device DD will be described in detail with reference to FIGS. 8 to 25. FIGS. 8 to 25 are sectional views illustrating, by process steps, a method of fabricating the display device DD.

FIG. 8 is a sectional view illustrating a display panel DP at the step of forming a pixel circuit layer PCL on a first substrate SUB1 and forming a first conductive connector CCM1 on the pixel circuit layer PCL.

Referring to FIG. 8, a first conductive material layer CCM1 may be formed on the first substrate SUB1 on which the pixel circuit layer PCL is formed.

The first substrate SUB1 and the pixel circuit layer PCL may be the same components as the substrate SUB and the pixel circuit layer PCL described with reference to FIG. 3. For the sake of convenience in explanation, in FIG. 8, the first substrate SUB1 and the pixel circuit layer PCL are denoted as a single layer SUB1/PCL. However, the first substrate SUB1 and the pixel circuit layer PCL that are formed as separate layers, e.g., the pixel circuit layer PCL is formed on the first substrate SUB1 may be included in the scope of the present disclosure. Hereinafter, redundant description thereof will be omitted.

The first conductive material layer CCM1 may be a component provided to form the first conductive connector CC1 described with reference to FIG. 6 through a fabrication process to be described later. In other words, the first conductive material layer CCM1 may include the same material as the first conductive connector CC1. In detail, the first conductive material layer CCM1 may be a conductive component and include a first barrier material layer BRLM1, a main material layer MNLM, and a second barrier material layer BRLM2. The first barrier material layer BRLM1, the main material layer MNLM, and the second barrier material layer BRLM2 may be sequentially stacked in the thickness direction DR3 of the first substrate SUB1.

The first barrier material layer BRLM1, the main material layer MNLM, and the second barrier material layer BRLM2 may also be components provided to form the first barrier layer BRL1, the main layer MNL, and the second barrier layer BRL2 described with reference to FIG. 6 through a fabrication process to be described later. In other words, the first barrier material layer BRLM1, the main material layer MNLM, and the second barrier material layer BRLM2 may respectively include the same materials as the first barrier layer BRL1, the main layer MNL, and the second barrier layer BRL2. Taking the foregoing into account, redundant explanation will be omitted below.

FIG. 9 is a sectional view illustrating the display panel at the step of forming a first semiconductor material layer SEMM1, an active material layer MQWM, and a second semiconductor material layer SEMM2 on a second substrate SUB2.

Referring to FIG. 9, the second substrate SUB2 may be prepared (or provided), and the first semiconductor material layer SEMM1, the active material layer MQWM, and the second semiconductor material layer SEMM2 may be formed sequentially on the second substrate SUB2.

The first semiconductor material layer SEMM1, the active material layer MQWM, and the second semiconductor material layer SEMM2 may be components respectively provided to form the second semiconductor layer SEM2, the active layer MQW, and the first semiconductor layer SEM1 described with reference to FIG. 6 through a fabrication process to be described later. In other words, the first semiconductor material layer SEMM1, the active material layer MQWM, and the second semiconductor material layer SEMM2 may respectively include the same materials as the second semiconductor layer SEM2, the active layer MQW, and the first semiconductor layer SEM1. Taking the foregoing into account, redundant explanation will be omitted below.

The second substrate SUB2 may be a base substrate allowing target materials to be stacked thereon. The second substrate SUB2 may be a wafer for epitaxial growth of a desired material. The second substrate SUB2 may be any one of a sapphire substrate, a GaAs substrate, a Ga substrate, an InP substrate, but the present disclosure is not limited thereto. For example, if a specific material can satisfy a selectivity for fabricating the light emitting element LD and smoothly induce epitaxial growth of the desired material, the specific material may be selected as the material of the second substrate SUB2.

The first semiconductor material layer SEMM1, the active material layer MQWM, and the second semiconductor material layer SEMM2 may be formed by growing seed crystals on the second substrate SUB2 according to an epitaxial method. For example, the first semiconductor material layer SEMM1, the active material layer MQWM, and the second semiconductor material layer SEMM2 may be formed by any one of the following methods: molecular beam epitaxy (MBE), vapor phase epitaxy (VPE), liquid phase epitaxy (LPE), electron beam deposition, physical vapor deposition (PVD), chemical vapor deposition (CVD), dual-type thermal evaporation, sputtering, and metal organic chemical vapor-phase deposition (MOCVD). However, the present disclosure is not limited thereto.

Precursor materials for forming the first semiconductor material layer SEMM1 and the second semiconductor material layer SEMM2 are not particularly limited, so long as the precursor materials fall within the range that can be typically selected to form the target materials. For example, the precursor material may be metal precursors that include alkyl groups such as methyl or ethyl groups. For example, the precursor material may include a compound such as trimethyl gallium (Ga(CH₃)₃), trimethyl aluminum (Al(CH₃)₃), or triethyl phosphate ((C₂H₅)₃PO₄), but is not limited thereto.

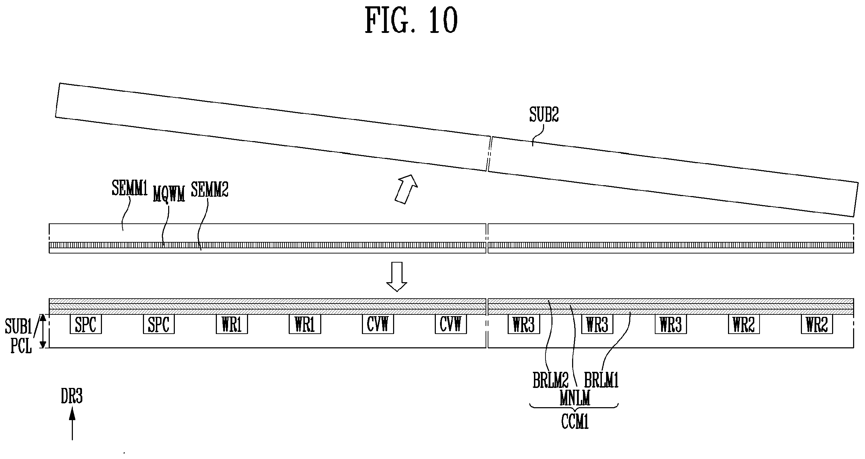

FIG. 10 is a sectional view illustrating the display panel at the step of bonding the first conductive material layer SEMM1 and the second semiconductor material layer SEMM2 to contact each other, and separating the second substrate SUB2 from the first semiconductor material layer SEMM1.

Referring to FIG. 10, the second substrate SUB2 on which the first semiconductor material layer SEMM1, the active material layer MQWM, and the second semiconductor material layer SEMM2 are sequentially stacked may be aligned on the first substrate SUB1 such that the second semiconductor material layer SEMM2 faces the second barrier material layer BRLM2 of the first conductive material layer CCM1.

When heat and pressure are applied in a direction which brings the first substrate SUB1 and the second substrate SUB2 closer to each other, while the second semiconductor material layer SEMM2 and the second barrier material layer BRLM2 are in contact with each other, the second semiconductor material layer SEMM2 and the second barrier material layer BRLM2 may be bonded to each other. After the second semiconductor material layer SEMM2 and the second barrier material layer BRLM2 are bonded to each other, the second substrate SUB2 may be separated from the first semiconductor material layer SEMM1.

Through the above-mentioned process, a structure may be obtained, in which the second semiconductor material layer SEMM2, the active material layer MQWM, and the first semiconductor material layer SEMM1 are sequentially stacked on the first conductive material layer CCM1.

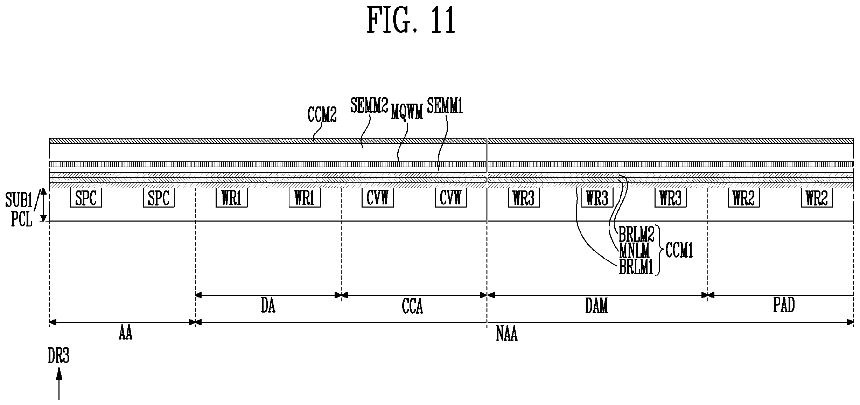

For reference, in FIG. 10, the designates "first" and "second" are given to the semiconductor material layers SEMM1 and SEMM2 based on the order in which the semiconductor material layers SEMM1 and SEMM2 are stacked on the second substrate SUB2 (i.e., in the order of SUB2, SEMM1, MQWM, and SEMM2). On the other hand, in the case of FIG. 6, the designations "first" and "second" are given to the semiconductor layers in the order in which the semiconductor layers are stacked on the first substrate SUB1. Hereinafter, for the sake of convenience in explanation, FIGS. 11 to 25 will be referenced, where the first semiconductor material layer SEMM1 and the second semiconductor material layer SEMM2 are sequentially designated in the order closer to the first substrate SUB1, in the same manner as that in FIG. 6. Taking the foregoing into account, redundant explanation will be omitted below.

FIG. 11 is a sectional view illustrating the display panel at the step of forming a second conductive material layer CCM2 on the second semiconductor material layer SEMM2.

Referring to FIG. 11, the second conductive material layer CCM2 may be formed on the second semiconductor material layer SEMM2.

The second conductive material layer CCM2 may be a component provided to form the second conductive connector CC2 described with reference to FIG. 6 through a fabrication process to be described later. In other words, the second conductive material layer CCM2 may include the same material as the second conductive connector CC2. Taking the foregoing into account, redundant explanation will be omitted below.

The second conductive material layer CCM2 may be formed of a transparent or translucent material with conductivity, and may be formed by physical vapor deposition (PVD) such as sputtering, or chemical vapor deposition (CVD), but the present disclosure is not limited thereto. For example, a deposition method such as a roll-to-roll method may be employed for a deposition of a material layer on flexible substrates.

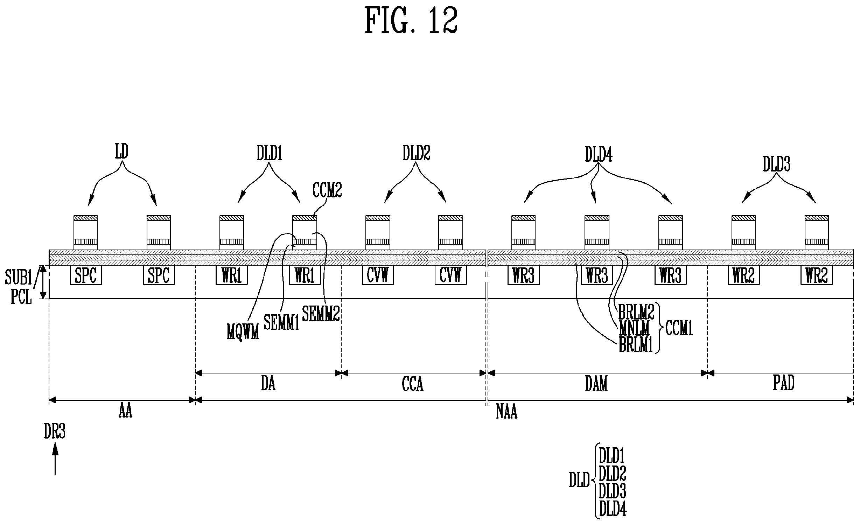

FIG. 12 is a sectional view illustrating the display panel at the step of forming a plurality of light emitting elements in the display area AA and a plurality of dummy light emitting elements in the non-display area NAA by removing portions of the second conductive material layer CCM2, the second semiconductor material layer SEMM2, the active material layer MQWM, and the first semiconductor material layer SEMM1.

Referring to FIG. 12, portions of the components formed on the first conductive connector CC1, i.e., the second conductive material layer CCM2, the second semiconductor material layer SEMM2, the active material layer MQWM, and the first semiconductor material layer SEMM1, may be removed. A dry etching method may be used as a method of removing portions of the second conductive material layer CCM2, the second semiconductor material layer SEMM2, the active material layer MQWM, and the first semiconductor material layer SEMM1, but the present disclosure is not limited thereto.

Remaining portions that are not removed at the present step may be formed into a plurality of light emitting elements LD and a plurality of dummy light emitting elements DLD. The light emitting elements LD and the dummy light emitting elements DLD may include substantially the same material. In other words, each of the light emitting elements LD and the dummy light emitting elements DLD may include the first semiconductor material layer SEMM1, the active material layer MQWM, the second semiconductor material layer SEMM2, and the second conductive material layer CCM2 in the same manner.

In detail, remaining portions of the first semiconductor material layer SEMM1, the active material layer MQWM, the second semiconductor material layer SEMM2, and the second conductive material layer CCM2 in the display area AA may be formed into respective light emitting elements LD which are electrically connected to the sub-pixel circuits SPC of the pixel circuit layer PCL.

Furthermore, remaining portions of the first semiconductor material layer SEMM1, the active material layer MQWM, the second semiconductor material layer SEMM2, and the second conductive material layer CCM2 in the dummy area DA may be formed into respective first dummy light emitting elements DLD1 which are contacting the first connection lines WR1 of the pixel circuit layer PCL.

Furthermore, remaining portions of the first semiconductor material layer SEMM1, the active material layer MQWM, the second semiconductor material layer SEMM2, and the second conductive material layer CCM2 in the cathode contact area CCA may be formed into respective second dummy light emitting elements DLD2 which are electrically connected to the common voltage lines CVW of the pixel circuit layer PCL.

In addition, remaining portions of the first semiconductor material layer SEMM1, the active material layer MQWM, the second semiconductor material layer SEMM2, and the second conductive material layer CCM2 in the pad area PAD may be formed into respective third dummy light emitting elements DLD3 which are electrically connected to the second connection lines WR2 of the pixel circuit layer PCL.

Furthermore, remaining portions of the first semiconductor material layer SEMM1, the active material layer MQWM, the second semiconductor material layer SEMM2, and the second conductive material layer CCM2 in the dam area DAM may be formed into respective fourth dummy light emitting elements DLD4 which are contacting the third connection lines WR3 of the pixel circuit layer PCL.

The fourth dummy light emitting elements DLD4 may be formed in a mesh shape in the dam area DAM and extend in a closed-loop shape surrounding the pad area PAD, unlike the first to third dummy light emitting elements DLD1 to DLD3 having a dotted shape from a viewpoint perpendicular to the plane formed in the first direction DR1 and the second direction DR2. The foregoing structure has been described in detail with reference to FIGS. 6 and 7, and thus more detailed descriptions thereof will be omitted.

The semiconductor material layers may be etched by a typical method. For example, a process of etching the semiconductor material layers may be performed by dry etching, wet etching, reactive ion etching (RIE), deep reactive ion etching (DRIE), inductively coupled plasma reactive ion etching (ICP-RIE), or the like. In the case of the dry etching, anisotropic etching is possible, which makes it suitable for vertical etching. In the case where the etching method mentioned above is employed, etchant may be chlorine (Cl₂), oxygen (O₂), or the like, but is not limited thereto.

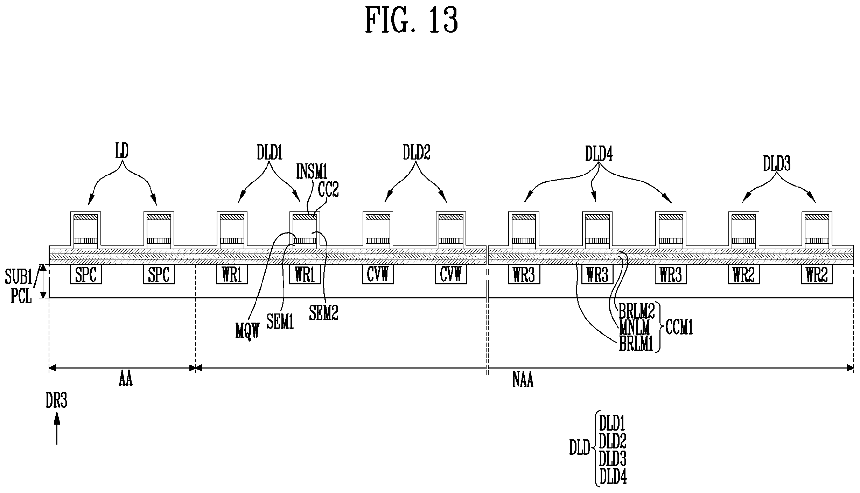

After the present step, remaining portions of the first semiconductor material layer SEMM1, the active material layer MQWM, the second semiconductor material layer SEMM2, and the second conductive material layer CCM2 will take no more process. Therefore, for the sake of convenience in explanation, in FIGS. 13 to 25, the first semiconductor material layer SEMM1, the active material layer MQWM, the second semiconductor material layer SEMM2, and the second conductive material layer CCM2 will be referred to as a first semiconductor layer SEM1, an active layer MQW, a second semiconductor layer SEM2, and a second conductive connector CC2.

FIG. 13 is a sectional view illustrating the display panel DP at the step of forming a first insulating material layer INSM1 on the first conductive material layer CCM1, the light emitting elements LD, and the dummy light emitting elements DLD.

Referring to FIG. 13, the first insulating material layer INSM1 may be formed in both the display area AA and the non-display area NAA across the entire surface of the display panel DP. The first insulating material layer INSM1 may cover a portion of the pixel circuit layer PCL where the light emitting elements LD and the dummy light emitting elements DLD are not formed, the side surfaces of the first semiconductor layer SEM1, the active layer MQW, the second semiconductor layer SEM2, and the second conductive connector CC2, and the top surface of the second conductive connector CC2.

The first insulating material layer INSM1 may be a component provided to form the first insulating layer INS1 described with reference to FIG. 6 through a fabrication process to be described later with reference to FIG. 6. In other words, the first insulating material layer INSM1 may include substantially the same material as the first insulating layer INS1. Taking the foregoing into account, redundant explanation will be omitted below.

The first insulating material layer INSM1 may be formed by atomic layer deposition (ALD), a sol-gel process, chemical vapor deposition such as plasma enhanced chemical vapor deposition (PECVD), or the like. However, the foregoing is merely illustrative, and the present disclosure is not limited thereto.

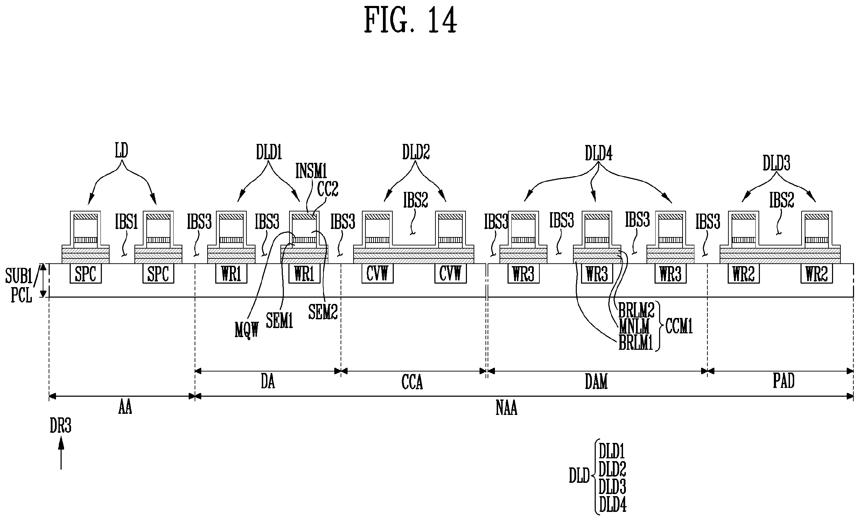

FIG. 14 is a sectional view illustrating the display panel DD at the step of removing portions of the first insulating material layer INSM1 and the first conductive material layer CCM1.

Referring to FIG. 14, portions of the first insulating material layer INSM1 and the first conductive material layer CCM1 that are positioned in space IBS3 between adjacent dummy light emitting elements DLD which are remaining areas, except for space IBS1 between adjacent light emitting elements LD and space IBS2 between adjacent second dummy light emitting elements DLD2 and adjacent third dummy light emitting elements DLD3, may be removed. As a result, the side surfaces of the first conductive connector CC1 and portions of the top surface of the pixel circuit layer PCL may be exposed. Dry etching may be employed as a method of removing portions of the first insulating material layer INSM1 and the first conductive material layer CCM1, but embodiments are not limited thereto.

With respect to the cathode contact area CCA and the pad area PAD, portions of the first insulating material layer INSM1 and the first conductive connector CC1 that are positioned in the space IBS2 between the second dummy light emitting elements DLD2 and the third dummy light emitting elements DLD3 may remain rather than being removed.

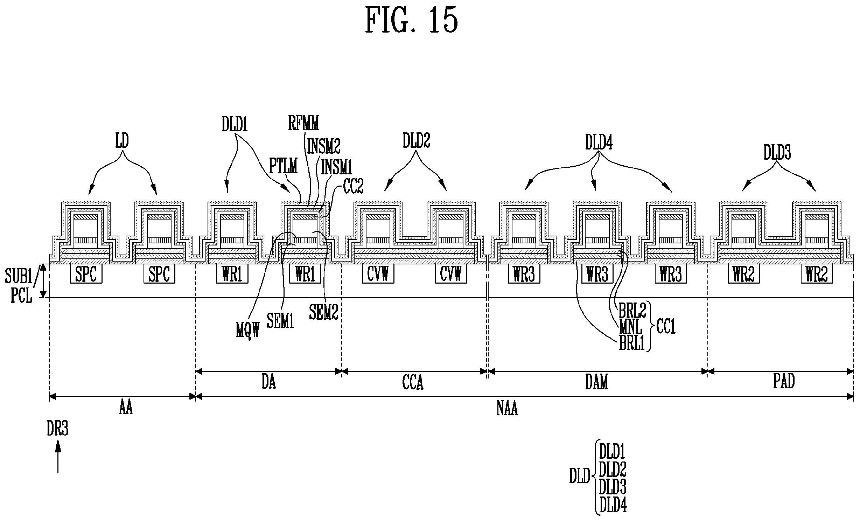

After the present step, remaining portions of the first conductive material layer CCM1 may take no more process. Hence, for the sake of convenience in explanation, in FIGS. 15 to 25, the first conductive material layer CCM1 will be referred to as a first conductive connector CC1.

FIG. 15 is a sectional view illustrating the display panel at the step of forming a second insulating material layer INSM2 on the first insulating material layer INSM1 and an exposed side surface of the first conductive connector CC1 and a portion of the top surface of the pixel circuit layer PCL, and forming a reflective material layer RFMM and a protective material layer PTLM on the second insulating material layer INSM2.

Referring to FIG. 15, the second insulating material layer INSM2 may be formed across the entire surface of the display panel DP. In other words, the second insulating material layer INSM2 may be formed across all of the display area AA, the dummy area DA, the cathode contact area CAA, the dam area DAM, and the pad area PAD.

The second insulating material layer INSM2, the reflective material layer RFMM, and the protective material layer PTLM may be the same components as the second insulating layer INS2, the reflective layer RFM, and the protective layer PTL described with reference to FIG. 6. Hereinafter, redundant descriptions will be omitted.

The second insulating material layer INSM2 may be formed by atomic layer deposition (ALD), a sol-gel process, chemical vapor deposition such as plasma enhanced chemical vapor deposition (PECVD), or the like. However, the foregoing is merely illustrative, and is not limited thereto.

The reflective material layer RFMM may also be formed across the entire surface of the display panel DP. In other words, the reflective material layer RFMM may also be formed across all of the display area AA, the dummy area DA, the cathode contact area CAA, the dam area DAM, and the pad area PAD. The reflective material layer RFMM may be formed by a metal deposition method such as sputtering, but it is not limited thereto.

The protective material layer PTLM may also be formed across the entire surface of the display panel DP. In other words, the protective material layer PTLM may also be formed across all of the display area AA, the dummy area DA, the cathode contact area CAA, the dam area DAM, and the pad area PAD. The protective material layer PTLM may be formed on the reflective material layer RFMM by the same method as the first insulating material layer INSM1 or the second insulating material layer INSM2.

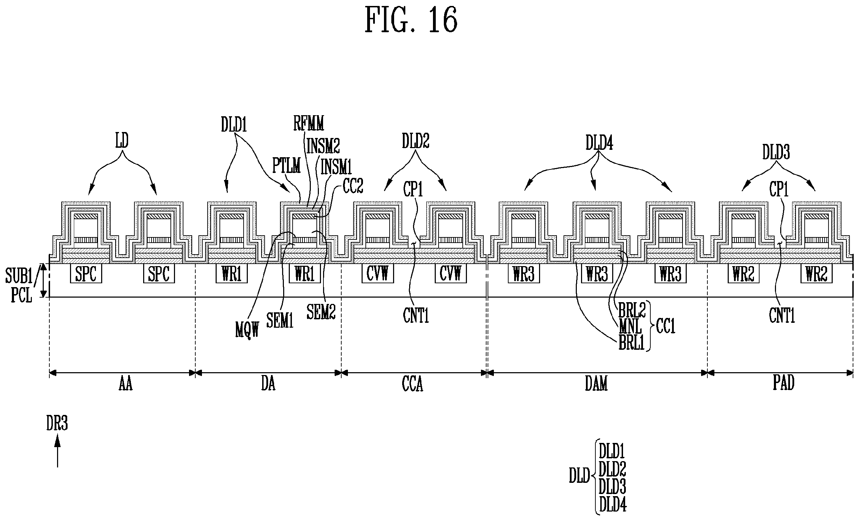

FIG. 16 is a sectional view illustrating the display panel at the step of forming first contact holes CNT1 by removing portions of the protective material layer PTLM, the reflective material layer RFMM, the second insulating material layer INSM2, and the first insulating material layer INSM1.

Referring to FIG. 16, a plurality of first contact holes CNT1 may be formed by removing portions of the protective material layer PTLM, the reflective material layer RFMM, the second insulating material layer INSM2, and the first insulating material layer INSM1 that are positioned in the space (refer to IBS2 in FIG. 14) between the second dummy light emitting elements DLD2 and the space (refer to IBS2 in FIG. 14) between the third dummy light emitting elements DLD3, thereby allowing portions of the top surfaces of the first conductive connectors CC1 positioned in the cathode contact area CAA and the pad area PAD to be exposed through the first contact holes CNT1. The first contact holes CNT1 may be formed through a dry etching process.

As the first contact holes CNT1 are formed, first cross-sections CP1 may be formed in the protective material layer PTLM, the reflective material layer RFMM, the second insulating material layer INSM2, and the first insulating material layer INSM1 that are positioned in the cathode contact area CCA and the pad area PAD. The first cross-sections CP1 may be aligned based on substantially the same direction as the third direction DR3.

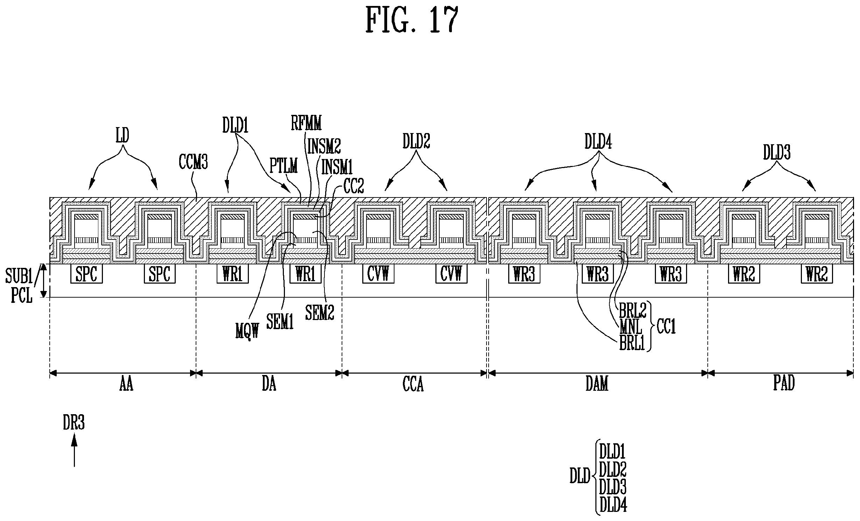

FIG. 17 is a sectional view illustrating the display panel DD at the step of forming a third conductive material layer CCM3 on the protective material layer PTLM and portions of the top surface of the first conductive connector CC1 exposed through the first contact holes CNT1.

Referring to FIG. 17, the third conductive material layer CCM3 may be formed across the entire surface of the display panel DP. In detail, the third conductive material layer CCM3 may cover the first cross-sections (refer to CP1 in FIG. 16), the entire top surface and side surface of the protective material layer PTLM, and portions of the top surface of the first conductive connector CC1 that are exposed through the first contact holes CNT1 formed between the adjacent second dummy light emitting elements DLD2 and between the adjacent third dummy light emitting elements DLD3.

The third conductive material layer CCM3 may be a component provided to form the metal mesh MM described with reference to FIG. 6 through a fabrication process to be described later. In other words, the third conductive material layer CCM3 may include the same material as the metal mesh MM. Taking the foregoing into account, redundant explanation will be omitted below.

The third conductive material layer CCM3 may be formed of a conductive metal material and, in an embodiment, may include copper (Cu). However, embodiments are not limited to the foregoing example, and the third conductive material layer CCM3 may include at least one selected from among copper (Cu), gold (Au), tin (Sn), titanium (Ti), aluminum (Al), and silver (Ag), or may be formed of an alloy thereof. The third conductive material layer CCM3 may be patterned through a damascene process, but the present disclosure is not limited thereto.

As such, as the third conductive material layer CCM3 with conductivity fills the first contact holes (refer to CNT1 in FIG. 16) and covers portions of the top surface of the first conductive connector CC1, the first conductive connector CC1 positioned in the cathode contact area CCA and the pad area PAD may be electrically connected to the third conductive material layer CCM3.

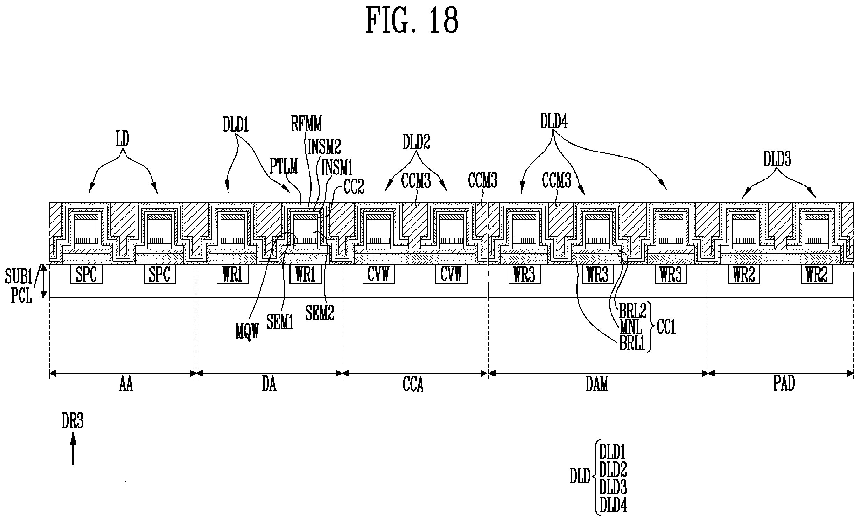

FIG. 18 is a sectional view illustrating the display panel at the step of planarizing the third conductive material layer CCM3 and exposing a portion of the protective material layer PTLM.

Referring to FIG. 18, an upper portion of the third conductive material layer CCM3 may be removed through a polishing process such as chemical-mechanical polishing (CMP), and/or an etching process. In detail, the polishing and/or etching process for the third conductive material layer CCM3 may be performed to planarize the third conductive material layer CCM3. At the previous step, the third conductive material layer CCM3 covers the protective material layer PTLM, and thus is formed at a higher position than the protective material layer PTLM in the thickness direction DR3 of the first substrate SUB1. Furthermore, although not illustrated in the drawings, the top surface of the third conductive material layer CCM3 after being formed through a deposition process may have a rough surface. The top surface of the third conductive material layer CCM3 may be processed with polishing and/or etching the third conductive material layer CCM3 to have a smooth surface and to expose the top surface of the protective layer PTL.

As described above, the third conductive material layer CCM3 is the same component as the metal mesh MM and is electrically connected to the first conductive connector CC1 in the cathode contact area CCA and the pad area PAD, as described with reference to FIG. 6, thus functioning as a connection electrode for receiving and transmitting signals to drive the display panel DP.

As such, the third conductive material layer CCM3 may not only be used as a component for electrical connection between components, but may also serve a role in planarization during an intermediate fabrication process, as described above.

Generally, in the fabrication process of the display panel DP, the planarization process may be performed by depositing an organic and/or inorganic layer that is relatively thicker than other insulating layers, and then polishing and/or etching the organic and/or inorganic layer. Even if the aforementioned process is performed, an additional process of depositing a conductive material may be further performed to electrically connect the components to each other.

By utilizing the third conductive material layer CCM3 to simultaneously achieve electrical connections and planarization, instead of depositing and planarizing a passivation layer, the number of patterning masks needed for the fabrication process may be reduced. As a result, embodiments may shorten the time to perform the fabrication process, and reduce the production cost.

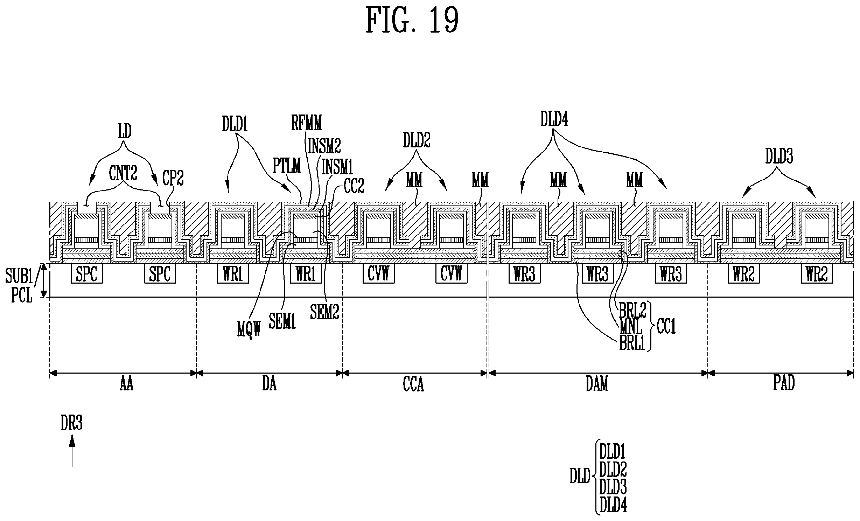

After the present step, the third conductive material layer CCM3 will take no more process. Therefore, in FIGS. 19 to 25, the third conductive material layer CCM3 will be referred to as a metal mesh MM.

FIG. 19 is a sectional view illustrating the display panel at the step of forming a plurality of second contact holes CNT2 by removing portions of the protective material layer PTLM, the reflective material layer RFMM, the second insulating material layer INSM2, and the first insulating material layer INSM1.

Referring to FIG. 19, the second contact holes CNT2 may be formed by removing portions of the protective material layer PTLM, the reflective material layer RFMM, the second insulating material layer INSM2, and the first insulating material layer INSM1 on the light emitting elements LD, thus allowing portions of the top surface of the second conductive connectors CC2 of the light emitting elements LD to be exposed through the second contact holes CNT2. The second contact holes CNT2 may be formed through a dry etching process.

As the second contact holes CNT2 are formed, second cross-sections CP2 may be formed in the protective material layer PTLM, the reflective material layer RFMM, the second insulating material layer INSM2, and the first insulating material layer INSM1 that are positioned in the display area AA. The second cross-sections CP2 may be aligned based on substantially the same direction as the third direction DR3.

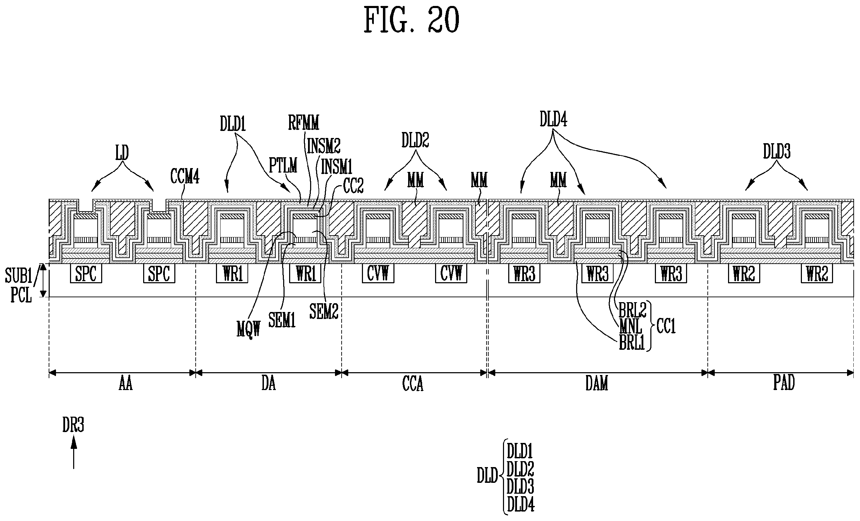

FIG. 20 is a sectional view illustrating the display panel DD at the step of forming a fourth conductive material layer CCM4 on the protective material layer PTLM and the second conductive connectors CC2 of the light emitting elements LD.

Referring to FIG. 20, the fourth conductive material layer CCM4 may be formed across the entire surface of the display panel DP. In detail, the fourth conductive material layer CCM4 may cover the second cross-sections (refer to CP2 in FIG. 19), portions of the top surfaces of the second conductive connectors CC2 of the light emitting elements LD that are exposed through the second contact holes CNT2, the top surface of the metal mesh MM, and the top surface of the protective material layer PTLM that is not covered with the metal mesh MM.

The fourth conductive material layer CCM4 may be a component provided to form the cathode electrode CE described with reference to FIG. 6 through a fabrication process to be described later. In other words, the fourth conductive material layer CCM4 may include the same material as the cathode electrode CE. Taking the foregoing into account, redundant explanation will be omitted below.

The fourth conductive material layer CCM4 may be formed of a transparent or translucent material with conductivity, and may be formed by physical vapor deposition (PVD) such as sputtering, or chemical vapor deposition (CVD), but the present disclosure is not limited thereto. For example, a deposition method such as a roll-to-roll method may be employed for a deposition of a material layer on flexible substrates.

As such, the fourth conductive material layer CCM4 with conductivity fills the second contact holes (refer to CNT2 in FIG. 19) and covers portions of the top surfaces of the second conductive connectors CC2. Hence, the second conductive connectors CC2 of the light emitting elements LD may be electrically connected to the fourth conductive material layer CCM4.

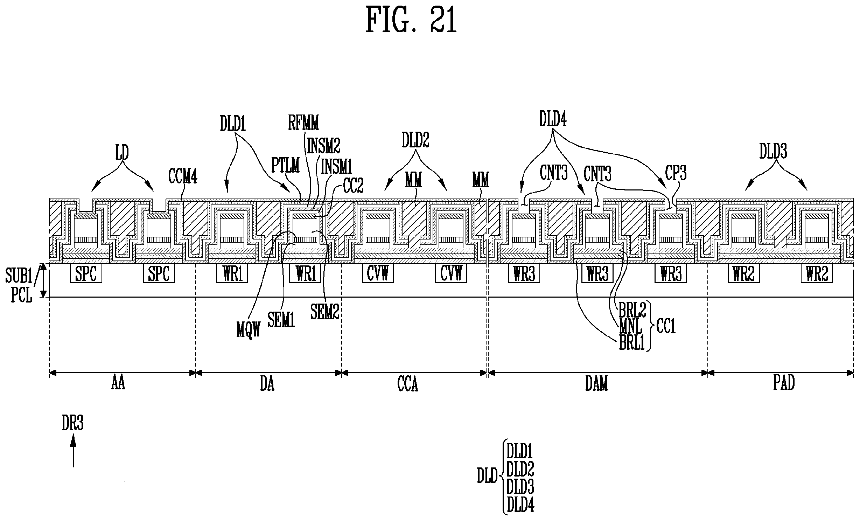

FIG. 21 is a sectional view illustrating the display panel DP at the step of forming a plurality of third contact holes CNT3 by removing portions of the fourth conductive material layer CCM4, the protective material layer PTLM, the reflective material layer RFMM, the second insulating material layer INSM2, and the first insulating material layer INSM1.

Referring to FIG. 21, the third contact holes CNT3 may be formed by removing portions of the fourth conductive material layer CCM4, the protective material layer PTLM, the reflective material layer RFMM, the second insulating material layer INSM2, and the first insulating material layer INSM1 on the fourth dummy light emitting elements DLD4, thus allowing portions of the top surface of the second conductive connectors CC2 of the fourth dummy light emitting elements DLD4 to be exposed through the third contact holes CNT3. The third contact holes CNT3 may be formed through a dry etching process, and may correspond to the trench TR described with reference to FIG. 6.

As the third contact holes CNT3 are formed, third cross-sections CP3 may be formed in the fourth conductive material layer CCM4, the protective material layer PTLM, the reflective material layer RFMM, the second insulating material layer INSM2, and the first insulating material layer INSM1 that are positioned in the dam area DAM. The third cross-sections CP3 may be aligned based on substantially the same direction as the third direction DR3.

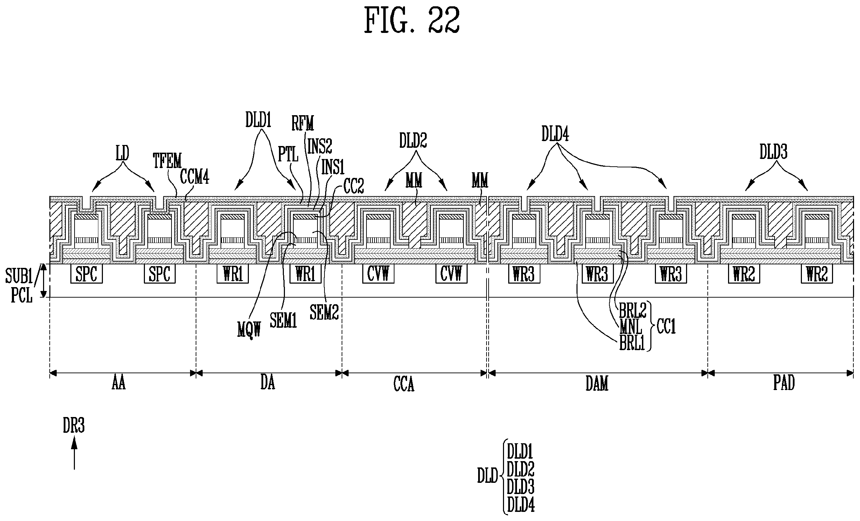

After the present step, the first insulating material layer INSM1, the second insulating material layer INSM2, the reflective material layer RFMM, the protective material layer PTLM, and the fourth conductive material layer CCM4 will take no more process. Hence, for the sake of convenience in explanation, in FIGS. 22 to 25, the first insulating material layer INSM1, the second insulating material layer INSM2, the reflective material layer RFMM, the protective material layer PTLM, and the fourth conductive material layer CCM4 will be respectively referred to as a first insulating layer INS1, a second insulating layer INS2, a reflective layer RFM, a protective layer PTL, and a cathode electrode CE.

FIG. 22 is a sectional view illustrating the step of forming a thin-film encapsulation material layer TFEM on the cathode electrode CE and the second conductive connectors CC2 of the fourth dummy light emitting elements DLD4.

Referring to FIG. 22, the thin-film encapsulation material layer TFEM may be formed across the entire surface of the display panel DP. In detail, the thin-film encapsulation material layer TFEM may cover the third cross-sections (refer to CP3 in FIG. 21), portions of the top surfaces of the second conductive connectors CC2 of the fourth dummy light emitting elements DLD4 that are exposed through the third contact holes CNP3, and the top surface of the fourth conductive material layer CCM4.

The thin-film encapsulation material layer TFEM may be a component provided to form the thin-film encapsulation layer TFE described with reference to FIG. 6 through a fabrication process to be described later. In other words, the thin-film encapsulation material layer TFEM may include the same material as the thin-film encapsulation layer TFE. Taking the foregoing into account, redundant explanation will be omitted below.

The thin-film encapsulation material layer TFEM may be formed by atomic layer deposition (ALD), molecular layer deposition (MLD), a sol-gel process, physical vapor deposition (PVD), chemical vapor deposition (CVD), Plasma Enhanced Chemical Vapor Deposition (PECVD), or the like, but the foregoing is merely illustrative, and embodiments are limited thereto.

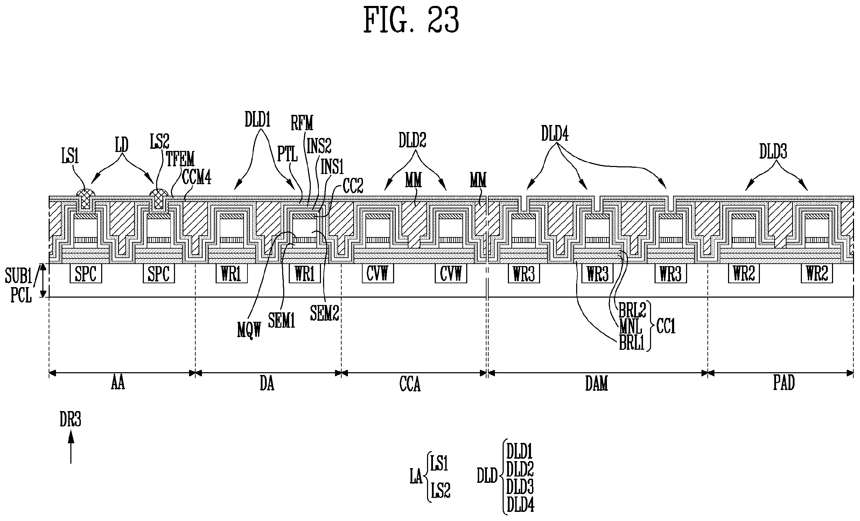

FIG. 23 is a sectional view illustrating the display panel at the step of forming a lens array LA on the light emitting elements LD.

Referring to FIG. 23, the lens array LA including a first lens LS1 and a second lens LS2 may be formed in a trench portion of the thin-film encapsulation material layer TFEM formed by processing the second contact hole (refer to CNT2 in FIG. 19) over the light emitting elements LD. The lens array LA may be formed as many as the number of light emitting elements LD to correspond to each of all light emitting elements LD formed in the display area AA.

The lens array LA illustrated in FIG. 23 may be the same component as the lens array LA described with reference to FIG. 6. Hereinafter, redundant descriptions will be omitted.

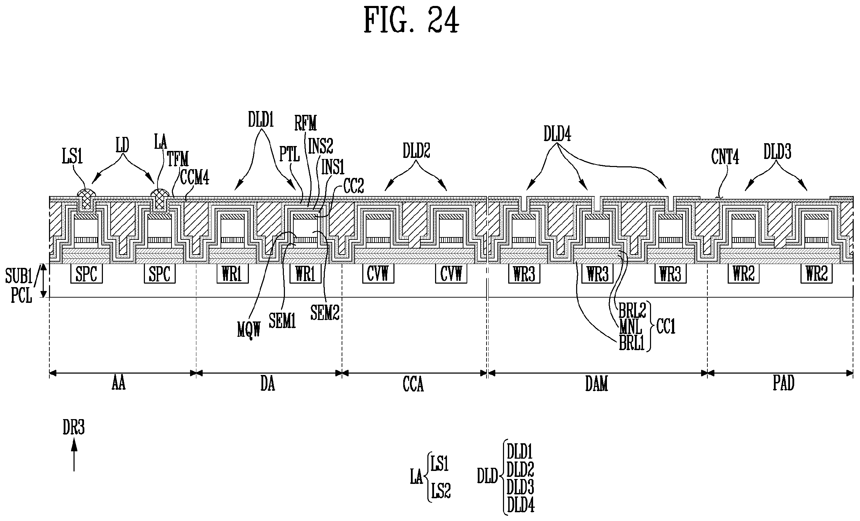

FIG. 24 is a sectional view illustrating the display panel DP at the step of forming a fourth contact hole CNT4 by removing a portion of the thin-film encapsulation material layer TFEM.

Referring to FIG. 24, the fourth contact hole CNT4 is formed by removing a portion of the thin-film encapsulation material layer TFEM positioned in the pad area PAD. As the fourth contact hole CNT4 is formed, the top surface of the cathode electrode CE positioned in the pad area PAD may be exposed. Dry etching may be employed as a method of removing a portion of the thin-film encapsulation material layer TFEM, but embodiments are limited thereto.

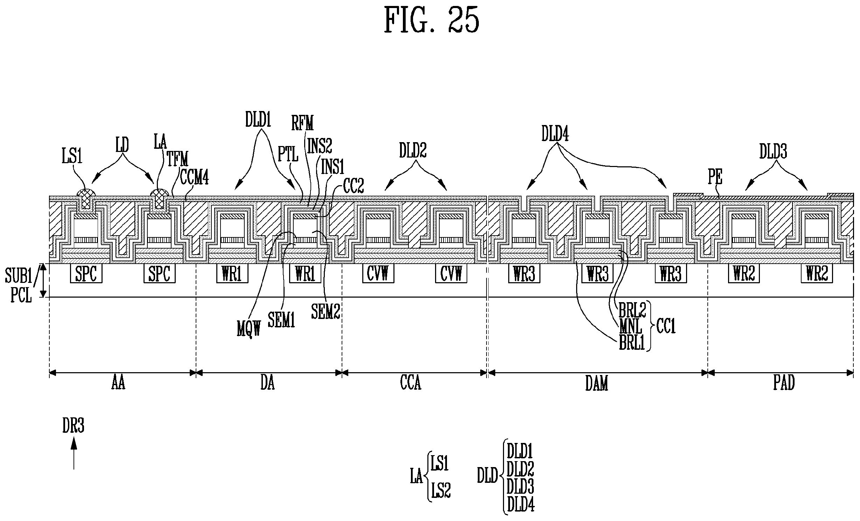

After the present step, the thin-film encapsulation material layer TFEM takes no more process. Hence, for the sake of convenience in explanation, in FIG. 25, the thin-film encapsulation material layer TFEM will be referred to as a thin-film encapsulation layer TFE.

FIG. 25 is a sectional view illustrating the display panel DP at the step of forming a pad electrode PE on the cathode electrode CE positioned in the pad area PAD.

Referring to FIG. 25, as the fourth contact hole (refer to CNT4 in FIG. 24) is formed, the pad electrode PE may be formed on an exposed portion of the cathode electrode CE.

The pad electrode PE illustrated in FIG. 25 may be the same component as the pad electrode PE described with reference to FIG. 6. Hereinafter, redundant descriptions will be omitted.

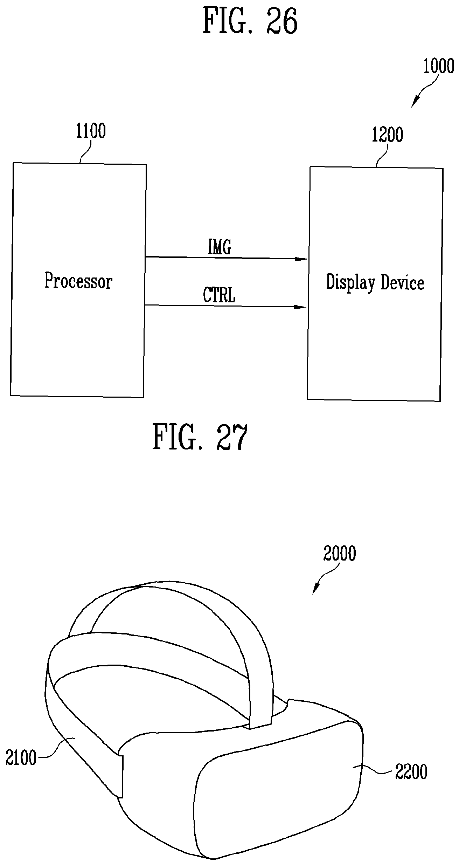

FIG. 26 is a block diagram illustrating an embodiment of a display system 1000.

Referring to FIG. 26, the display system 1000 may include a processor 1100 and a display device 1200.

The processor 1100 may perform various tasks and operations. The processor 1100 may include an application processor, a graphic processor, a microprocessor, a central processing unit (CPU), and so on. The processor 1100 may be connected to the other components of the display system 1000 through a bus system to control the components.

The processor 1100 may transmit image data IMG and a control signal CTRL to the display device 1200. The display device 1200 may display an image based on the image data IMG and the control signal CTRL. The display device 1200 may be configured in the same manner as the display device DD described with reference to FIG. 1. In such a case, the image data IMG and the control signal CTRL may be provided as the input image data IMG and the control signal CTRL of FIG. 1, respectively.

The display system 1000 may include computing systems that provide an image display function, such as a smart watch, a mobile phone, a smart phone, a portable computer, a tablet personal computer (tablet PC), a watch phone, an automotive display, smart glasses, a portable multimedia player (PMP), a navigation system, and an ultra mobile personal computer (UMPC). Furthermore, the display system 1000 may include at least one of a head-mounted display (HMD), a virtual reality (VR) device, a mixed reality (MR) device, and an augmented reality (AR) device.

FIG. 27 is a perspective diagram illustrating an application example of the display system 1000 of FIG. 26.

Referring to FIG. 27, the display system 1000 of FIG. 26 may be applied to a head-mounted display device 2000. The head-mounted display device 2000 may be a wearable electronic device, which can be worn on the head of the user.

The head-mounted display 2000 may include a head-mounted band 2100 and a display device reception casing 2200. The head-mounted band 2100 may be connected to the display device reception casing 2200. The head-mounted band 2100 may include a horizontal band and/or a vertical band to fasten the head-mounted display 2000 to the head of the user. The horizontal band may surround the sides of the head of the user, and the vertical band may surround the top of the head of the user. However, the embodiments are not limited to the aforementioned example. For example, the head-mounted band 2100 may be implemented in the form of eyeglass frames, a helmet, and so on.

The display device reception casing 2200 may accommodate the display device 1200 of FIG. 26. The display device reception casing 2200 may further include the processor 1100 of FIG. 26.

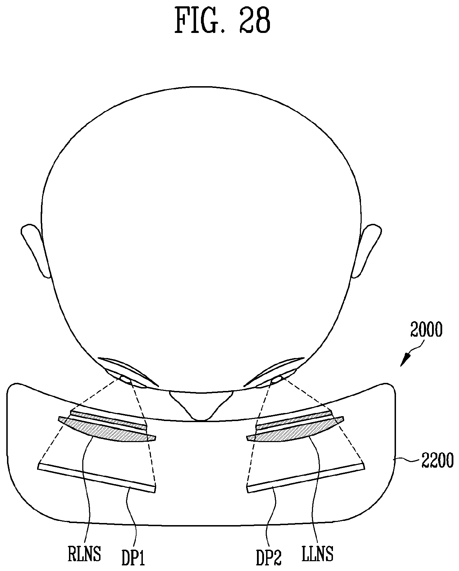

FIG. 28 is a diagram illustrating the head-mounted display device 2000 of FIG. 27 that is worn by a user.

Referring to FIG. 28, a first display panel DP1 and a second display panel DP2 of the display device DD may be disposed in the head-mounted display device 2000. The head-mounted display device 2000 may further include one or more lenses LLNS and RLNS.

In the display device reception casing 2200, the right-eye lens RLNS may be positioned between the first display panel DP1 and the right eye of the user. Furthermore, in the display device reception casing 2200, the left-eye lens LLNS may be positioned between the second display panel DP2 and the left eye of the user.

An image output from the first display panel DP1 can be viewed by the right eye of the user through the right-eye lens RLNS. The right lens RLNS may refract light emitted from the first display panel DP1 toward the right eye of the user. The right-eye lens RLNS may perform an optical function to adjust a viewing distance between the first display panel DP1 and the right eye of the user.

An image output from the second display panel DP2 can be viewed by the left eye of the user through the left-eye lens LLNS. The left lens LLNS may refract light emitted from the second display panel DP2 toward the left eye of the user. The left-eye lens LLNS may perform an optical function to adjust a viewing distance between the second display panel DP2 and the left eye of the user.

Each of the right-eye lens RLNS and the left-eye lens LLNS may include an optical lens having a pancake-shaped cross-section. Each of the right-eye lens RLNS and the left-eye lens LLNS may include a multi-channel lens including sub-areas having different optical characteristics. In such a case, each display panel may output images respectively corresponding to sub-areas of the multi-channel lens. The output images may be viewed to the user through the corresponding sub-areas.

In accordance with a display device and a method of fabricating the display device according to embodiments, the time to perform a fabrication process may be shortened, and the production cost may be reduced. For example, light emitting elements may be provided not only in a display area but also in a non-display area, and a metal mesh functioning as a connection electrode may be disposed between the light emitting elements. The light emitting elements and the metal mesh may serve a role in planarization during the fabrication process. Consequently, a process of depositing and planarizing a separate insulating layer may be omitted, thereby the time needed for a display device and a method of fabricating the display device may be shortened, and the production cost may be reduced.

In accordance with a display device and a method of fabricating the display device according to embodiments, the risk of electrical short-circuits may be reduced. For example, a pad area in a display element component may be surrounded by a dam area in which at least one trench covered with an insulating material is formed. Accordingly, the risk of electrical short-circuits may be reduced.

However, effects of the present disclosure are not limited to the above-described effects, and various modifications are possible without departing from the scope of the present invention as defined by the claims.

## Claims

1. A display device including a display area and a non-display area formed around the display area, the display device comprising:
a substrate;
a pixel circuit layer disposed on the substrate, and including a plurality of sub-pixel circuits disposed in the display area;
a plurality of first conductive connectors disposed on the pixel circuit layer, the plurality of first conductive connectors including first conductive connectors disposed in the display area and first conductive connectors disposed in the non-display area; and
a display element layer disposed on the first conductive connectors,
wherein the display element layer includes a plurality of light emitting elements disposed in the display area, electrically connected to the sub-pixel circuits through the first conductive connectors disposed in the display area and configured to emit light in response to signals applied from the sub-pixel circuits, and a plurality of dummy light emitting elements disposed in the non-display area,
wherein the light emitting elements and the dummy light emitting elements comprise the same material.

2. The display device according to claim 1,
wherein each of the light emitting elements and the dummy light emitting elements comprises:
a first semiconductor layer disposed on the first conductive connectors;
an active layer disposed on the first semiconductor layer;
a second semiconductor layer disposed on the active layer; and
a second conductive connector disposed on the second semiconductor layer,
wherein the first semiconductor layer, the active layer, the second semiconductor layer, and the second conductive connector are sequentially stacked in a thickness direction of the substrate,
wherein the first conductive connectors disposed in the display area are in contact with the light emitting elements and are connected to the sub-pixel circuits, and
wherein the first conductive connectors disposed in the non-display area are in contact with the dummy light emitting elements and are separated from the sub-pixel circuits.

3. The display device according to claim 2,
wherein the non-display area includes a dummy area surrounding the display area, a cathode contact area surrounding the dummy area, a pad area spaced apart from the cathode contact area, and a dam area surrounding the pad area,
wherein the dummy light emitting elements comprises:
a plurality of first dummy light emitting elements disposed in the dummy area;
a plurality of second dummy light emitting elements disposed in the cathode contact area;
a plurality of third dummy light emitting elements disposed in the pad area; and
a plurality of fourth dummy light emitting elements disposed in the dam area, and
wherein a cross-section of the first dummy light emitting elements, the second dummy light emitting elements, the third dummy light emitting elements, or the fourth dummy light emitting elements is identical to a cross-section of the light emitting elements disposed in the display area along the thickness direction.

4. The display device according to claim 3, wherein the fourth dummy light emitting elements extend in a closed-loop shape along the dam area.

5. The display device according to claim 3 or 4,
wherein the display element layer further includes:
an insulating layer covering at least portions of top surfaces of and side surfaces of the first conductive connectors, the light emitting elements, and the dummy light emitting elements;
a reflective layer disposed on the insulating layer and configured to guide light emitted from the light emitting elements in the thickness direction;
a protective layer disposed on the reflective layer; and
a metal mesh disposed on the protective layer in space between the light emitting elements adjacent to each other, space between the dummy light emitting elements adjacent to each other, and space between any one of the light emitting elements and any one of the dummy light emitting elements adjacent to each other, and
wherein a portion of a top surface of the protective layer is not covered by the metal mesh.

6. The display device according to claim 5,
wherein the insulating layer, the reflective layer, and the protective layer include:
a plurality of first contact holes extended to at least portions of the top surfaces of the light emitting elements, and
a trench extending to portions of the top surfaces of the fourth dummy light emitting elements.

7. The display device according to claim 6,
wherein the display element layer further includes a cathode electrode disposed on the protective layer and the metal mesh,
wherein the cathode electrode is electrically connected to the top surface of the light emitting elements through the first contact holes, and
wherein a portion of the cathode electrode that is formed in the cathode contact area and a portion of the cathode electrode that is formed in the pad area are separated from each other by the trench disposed in the dam area.

8. The display device according to claim 7,
wherein the display element layer further includes a thin-film encapsulation layer disposed on the cathode electrode, and
wherein the thin-film encapsulation layer contacts the top surface of each of the fourth dummy light emitting elements through the trench.

9. The display device according to claim 7,
wherein the insulating layer, the reflective layer, and the protective layer further include:
a plurality of second contacts extending to at least portions of the top surfaces of the first conductive connectors contacting the second dummy light emitting elements; and
a plurality of third contact holes extending to at least portions of the top surfaces of the first conductive connectors contacting the third dummy light emitting elements,
wherein a first end of the metal mesh disposed in the cathode contact area is electrically connected to at least portions of the top surfaces of the first conductive connectors contacting the second dummy light emitting elements through the second contact holes,
wherein a second end of the metal mesh disposed in the cathode contact area is electrically connected to the cathode electrode,
wherein a first end of the metal mesh disposed in the pad area is electrically connected to at least portions of the top surfaces of the first conductive connectors contacting the third dummy light emitting elements through the third contact holes, and
wherein a second end of the metal mesh disposed in the pad area is electrically connected to the cathode electrode.

10. The display device according to claim 9,
wherein the thin-film encapsulation layer includes a fourth contact hole extending to a top surface of the cathode electrode disposed in the pad area, and
wherein the display element layer further includes a pad electrode disposed on the thin-film encapsulation layer and electrically connected to the cathode electrode through the fourth contact hole.

11. A method of fabricating a display device including a display area and a non-display area surrounding the display area, the method comprising:
forming, on a first substrate, a pixel circuit layer in which a plurality of sub-pixel circuits is disposed;
forming a first conductive material layer on the pixel circuit layer;
sequentially forming a first semiconductor material layer, an active material layer, and a second semiconductor material layer on a second substrate;
bonding the first conductive material layer and the second semiconductor material layer to contact each other, and separating the second substrate from the first semiconductor material layer;
forming a second conductive material layer on the first semiconductor material layer; and
forming a plurality of light emitting elements disposed in the display area and a plurality of dummy light emitting elements disposed in the non-display area by removing portions of the second conductive material layer, the first semiconductor material layer, the active material layer, and the second semiconductor material layer.

12. The method according to claim 11, further comprising forming a first insulating material layer on the second conductive material layer, the light emitting elements, and the dummy light emitting elements, further comprising:
removing portions of the first insulating material layer and the first conductive material layer, wherein a side surface of the first conductive material layer and a portion of a top surface of the pixel circuit layer are exposed;
forming a second insulating material layer on the first insulating material layer, the exposed side surface of the first conductive material layer and the exposed portion of the top surface of the pixel circuit layer;
forming a reflective material layer on the second insulating material layer; and
forming a protective material layer on the reflective material layer.

13. The method according to claim 12, further comprising:
forming a third conductive material layer on the protective material layer; and
planarizing the third conductive material layer, wherein a portion of the protective material layer is exposed through the planarization of the third conductive material layer.

14. The method according to claim 13, further comprising:
forming a plurality of first contact holes by removing portions of the protective material layer, the reflective material layer, the second insulating material layer, and the first insulating material layer, wherein at least a portion of a top surface of the second conductive material layer disposed in the display area is exposed through the first contact holes; and
forming a fourth conductive material layer on the protective material layer and the third conductive material layer, wherein the fourth conductive material layer is electrically connected to the second conductive material layer disposed in the display area through the first contact holes, or
forming a fourth conductive material layer on the exposed portion of the protective material layer and the third conductive material layer; and
forming a thin-film encapsulation material layer on the fourth conductive material layer, or
forming a fourth contact hole by removing portions of the fourth conductive material layer, the protective material layer, the reflective material layer, the second insulating material layer, and the first insulating material layer, wherein a top surface of the second conductive material layer disposed in the non-display area is exposed through the fourth contact hole; and
forming a thin-film encapsulation material layer on the top surface of the second conductive material layer exposed through the fourth contact hole, the first insulating material layer, the second insulating material layer, the reflective material layer, a portion of the protective material layer, and the fourth conductive material layer.

15. The method according to claim 12, further comprising:
forming a second insulating material layer on the first insulating material layer;
forming a reflective material layer on the second insulating material layer; and
forming a protective material layer on the reflective material layer, further comprising:
forming a plurality of second contact holes by removing portions of the protective material layer, the reflective material layer, the second insulating material layer, and the first insulating material layer, wherein a portion of a top surface of the first conductive material layer disposed in the non-display area is exposed through the second contact holes;
forming a third conductive material layer on the protective material layer and the exposed portion of the top surface of the first conductive material layer disposed in the non-display area, wherein the third conductive material layer is electrically connected to the first conductive material layer through the second contact holes; and
forming a metal mesh by planarizing the third conductive material layer, wherein a portion of the protective material layer is exposed through the planarization of the third conductive material layer, optionally further comprising:
forming a fourth conductive material layer on the protective material layer and the metal mesh; and
forming a thin-film encapsulation material layer on the fourth conductive material layer.
